# EUROPEAN PATENT SPECIFICATION

(11) **EP 4 402 723 B1**
(45) Date of publication and mention of the grant of the patent: **25.02.2026**
(21) Application number: 21794371.1
(22) Date of filing: 18.10.2021
(51) Int. Cl.: H10D 30/47, H10D 30/01, H10D 62/10, H10D 62/17, H10D 62/824, H10D 64/23, H10D 62/85, H10D 62/815

(54) **TRANSISTOR DEVICES, POWER DEVICES, AND METHOD OF MANUFACTURING THEREOF**
TRANSISTORVORRICHTUNGEN, LEISTUNGSVORRICHTUNGEN UND VERFAHREN ZUR HERSTELLUNG DAVON
DISPOSITIFS À TRANSISTORS, DISPOSITIFS D'ALIMENTATION ET LEUR PROCÉDÉ DE FABRICATION

(43) Date of publication of application: 24.07.2024
(73) Proprietor: Huawei Technologies Co., Ltd., Shenzhen, Guangdong 518129 (CN)
(72) Inventor: CURATOLA, Gilberto, 80992 Munich (DE)
(74) Representative: Maiwald GmbH
(86) International application number: PCT/EP2021/078757
(87) International publication number: WO 2023/066439

(56) References cited:
- CN-A- 111 490 100
- US-A1- 2018 219 086
- SHANKAR BHAWANI ET AL: "Safe Operating Area of Polarization Super-junction GaN HEMTs and Diodes", IEEE TRANSACTIONS ON ELECTRON DEVICES, IEEE, USA, vol. 66, no. 10, October 2019 (2019-10-01), pages 4140 - 4147, XP011746751, ISSN: 0018-9383, [retrieved on 20190919], DOI: 10.1109/TED.2019.2933362

## Description

### TECHNICAL FIELD

The present disclosure relates generally to the field of semiconductor devices and more specifically, to a member (e.g., a semiconductor structure), transistor devices, power devices.

### BACKGROUND

B. Shankar and M. Shrivastava, "Safe Operating Area of Polarization Super-junction GaN HEMTs and Diodes", IEEE Transactions on Electron Devices, Vol. 66, 2019, pages 4140-4147, is an article that reports safe operating area (SOA) assessment in polarization super-junction (PSJ)-based GaN high-electron mobility transistor (HEMT) and Schottky diode. It is described that the degradation physics, which limits SOA in these devices under high-voltage and high-current-injection conditions is presented. It is described that trap-induced SOA degradation and the role of PSJ in SOA improvement are unveiled. It is described that in PSJ-field-effect transistor (FET), the impact of PSJ length and its position on SOA robustness are studied. It is described that the role of self-heating and substrate effect on degradation are discussed. It is described that PSJ diodes with different configurations of Schottky contact are investigated. It is described that the correlation between PSJ length and failure threshold is presented, besides power and field dependence of SOA boundary.

US2018/219086A1 describes that a nitride semiconductor device includes a horizontal switching device that includes a substrate, a channel forming layer, a source region, a drain region and a gate region. It is described that the source region and the drain region are arranged apart from each other in one direction along a plane of the substrate. It is described that the gate region is formed of a p-type semiconductor layer and is arranged between the source region and the drain region. It is described that the gate region is divided into multiple parts in a perpendicular direction along the plane of the substrate, the perpendicular direction being perpendicular to an arrangement direction in which the source region and the drain region are arranged.

Generally, a semiconductor device is based on electronic properties of a semiconductor material, such as silicon (Si), germanium (Ge), and the like, for its functioning. The semiconductor device is generally manufactured either as an individual device or as an integrated circuit (IC) device, for example, using a conventional silicon-based semiconductor technology. However, the conventional silicon-based semiconductor technology has certain limits in terms of on-state resistance versus breakdown voltage. There is a super junction concept that has been extensively proven and applied to the conventional silicon-based semiconductor technology to surpass such limits. In the super junction concept, p-type doped vertical stripes are added in a drift region of the semiconductor device, which results in the formation of new PN-junctions. The super junction concept allows achieving a flat electric field distribution in the semiconductor device due to lateral depletion of an adjacent PN-junction (i.e., cool metal oxide semiconductor (MOS)). Because of the flat electric field distribution, the super junction concept manifests a much higher doping profile and reduces a minimum achievable on-state resistance.

Currently, intensive efforts are taken to develop a possible replacement of the conventional silicon technology (or Si-based field-effect transistors (FETs)), for example, by the development of wide bandgap (WBG) semiconductor materials-based technology. The wide bandgap semiconductor materials provide a partially better performance both at a device level as well as at a system level as compared to the conventional silicon-based semiconductor technology. For example, conventional enhancement-mode gallium nitride (GaN) based power FETs are already used by semiconductor manufacturers in various conventional products. Such wide bandgap semiconductor materials (e.g., gallium nitride) based power FETs (or MOSFET) utilize p-doped GaN normally-off concept that uses, generally, a single aluminium gallium nitride (AlGaN) barrier layer. It is known that GaN based semiconductor devices are by nature normally-on devices, however, power electronics industry, strongly desires normally-off devices. The conventional wide bandgap semiconductor materials-based power transistors manifest several drawbacks. The first drawback is that the threshold voltage and the on-state resistance of the semiconductor device cannot be controlled independently. On the contrary, the on-state resistance of the semiconductor device can be lowered but at the expense of also lowering the threshold voltage (V_{TH}) of the semiconductor device, which is very detrimental because of an increased off-state leakage and because of unwanted risks of the semiconductor device spurious turn-on. Another important drawback of the conventional wide bandgap semiconductor materials-based power transistors is a high electric field at the gate-drain edge of the semiconductor device. The high electric field represents a very serious concern for the reliability of the semiconductor device, which is generally mitigated with the use of a complex field plate design. Thus, the most effective and simplified way to reduce the high (or maximum) electric field and to improve the reliability of the semiconductor device is by sacrificing the overall performance of the semiconductor device, which is again not desirable. Therefore, there exists a technical problem of how to improve the reliability of the semiconductor device without sacrificing the performance of the semiconductor device.

Therefore, in light of the foregoing discussion, there exists a need to overcome the aforementioned drawbacks associated with the conventional semiconductor device.

### SUMMARY

Appended claim 1 defines a member. Appended claim 13 defines a metal-semiconductor field-effect transistor (MESFET) device. Appended claim 14 defines a power device. The invention and its scope of protection is defined by these claims.

The present disclosure provides a member, transistor devices, power devices, and a method for manufacturing the member, where the method is not part of the claimed invention. The present disclosure provides a solution to the existing problem of how to improve the reliability of the semiconductor device without sacrificing the performance of the semiconductor device. An objective of the present disclosure is to provide a solution that overcomes at least partially the problems encountered in the prior art and provide an improved member, transistor device, power device, and a method for manufacturing the member with enhanced high voltage operation, where the method is not part of the claimed invention, where the member effectively improves the performance of a semiconductor device without sacrificing the performance of the semiconductor device.

One or more objectives of the present disclosure is achieved by the solutions provided in the enclosed independent claims. Advantageous implementations of the present disclosure are further defined in the dependent claims.

In one aspect, the present disclosure provides a member comprising, a silicon base substrate layer, a transition layer arranged over the silicon base substrate layer, a gallium nitride (GaN) buffer layer arranged over the transition layer, a first aluminium gallium nitride (AlGaN) barrier layer arranged over the gallium nitride (GaN) buffer layer, and a first p-doped gallium nitride (pGaN) layer arranged over the first aluminium gallium nitride (AlGaN) barrier layer, wherein a portion of the gallium nitride (GaN) buffer layer forming a first gallium nitride (GaN) channel layer, and wherein the first gallium nitride (GaN) channel layer, the first aluminium gallium nitride (AlGaN) barrier layer and the first p-doped gallium nitride (pGaN) layer forming a first epitaxial stack. The member further comprises a second gallium nitride (GaN) channel layer arranged over the first p-doped gallium nitride (pGaN) layer, a second aluminium gallium nitride (AlGaN) barrier layer arranged over the second gallium nitride (GaN) channel layer, a second p-doped gallium nitride (pGaN) layer arranged over the second barrier aluminium gallium nitride (AlGaN) barrier layer, a gate contact arranged over the second p-doped gallium nitride (pGaN) layer, a source contact arranged over the first aluminium gallium nitride (AlGaN) barrier layer, and a drain contact arranged over the first aluminium gallium nitride (AlGaN) barrier layer, wherein the second p-doped gallium nitride (pGaN) layer is connected to the first p-doped gallium nitride (pGaN) layer by a connecting p-doped gallium nitride (pGaN) portion extending through a space in the second aluminium gallium nitride (AlGaN) barrier layer and the second gallium nitride (GaN) channel layer, and wherein the first p-doped gallium nitride (pGaN) layer is arranged between the source contact and the drain contact. The member of the present disclosure is a semiconductor structure that enables drastic reduction in an electric field peak at an edge of the gate contact and the drain contact (or at gate-drain edge). Moreover, due to the use of the second aluminium gallium nitride barrier layer, a flat electric field distribution is achieved along the first aluminium gallium nitride barrier layer and the second aluminium gallium nitride barrier layer of the member. The member further achieves an improved breakdown voltage (BV), which in turn allows having a drastic reduction in dimensions of a semiconductor device (e.g., a transistor device or a power device) for the same target breakdown voltage. In addition, the first epitaxial stack and the second epitaxial stack of the member are beneficial to improve the performance and overall reliability of the member. Alternatively stated, the disclosed member improves the reliability of a semiconductor device without sacrificing the overall performance of the semiconductor device and manifests an enhanced high voltage operation capability.

The gate contact is arranged over the connecting p-doped gallium nitride (pGaN) portion. In this implementation, the gate contact that is arranged over the connecting p-doped gallium nitride portion is also in direct contact with a first p-doped gallium nitride layer and a second p-doped gallium nitride layer. As a result, there is a minimum resistance between the gate contact and the first p-doped gallium nitride layer.

In another implementation form, the connecting p-doped gallium nitride (pGaN) portion connecting the first p-doped gallium nitride (pGaN) layer and second p-doped gallium nitride (pGaN) layer is arranged to extend above an upper surface of the second p-doped gallium nitride (pGaN) layer.

In this implementation, the gate contact arranged over the connecting p-doped gallium nitride portion can be used for further electrical connection with an external power supply.

In yet another implementation form, the first gallium nitride (GaN) channel layer thickness is in the range, the first aluminium gallium nitride (AlGaN) barrier layer thickness is in the range, the first p-doped gallium nitride (pGaN) layer thickness is in the range, the second gallium nitride (GaN) channel layer thickness is in the range, the second aluminium gallium nitride (AlGaN) barrier layer thickness is in the range, and/or the second p-doped gallium nitride (pGaN) layer thickness is in the range.

By virtue of using alternative thickness for different layers, the member can achieve either a desired performance and a desired reliability.

In another implementation form, the first gallium nitride (GaN) channel layer has a doping degree in the range, the first aluminium gallium nitride (AlGaN) barrier layer has a doping degree in the range, the first p-doped gallium nitride (pGaN) layer has a doping degree in the range, the second gallium nitride (GaN) channel layer has a doping degree in the range, the second aluminium gallium nitride (AlGaN) barrier layer has a doping degree in the range, and/or the second p-doped gallium nitride (pGaN) layer has a doping degree in the range.

The doping degree can be adjusted for different layers of the member so that the member can achieve a desired performance as well as a desired reliability.

In yet another implementation form, the member further comprises a passivation layer arranged over the second p-doped gallium nitride (pGaN) layer and wherein the connecting p-doped gallium nitride (pGaN) portion extends through in the passivation layer.

The passivation layer is beneficial to prevent oxidation of the second p-doped gallium nitride layer.

In another implementation form, the passivation layer extends between the source contact and the first p-doped gallium nitride (pGaN) layer and between the drain contact and the first p-doped gallium nitride (pGaN) layer.

In this implementation, the passivation layer provides a lateral isolation between the source contact, and the first p-doped gallium nitride layer, and also between the drain contact and the first p-doped gallium nitride layer. Moreover, the passivation layer reduces all possible leakage paths, especially at high voltage.

In yet another implementation form, the passivation layer comprises aluminium oxide, aluminium nitride, silicon dioxide or silicon nitride.

The passivation layer provides an improved isolation between the source contact and the first p-doped gallium nitride layer, and between the drain contact and the first p-doped gallium nitride layer.

In another implementation form, the member further comprises at least one intermediate gallium nitride (GaN) channel layer, at least one intermediate aluminium gallium nitride (AlGaN) barrier layer arranged over the at least one intermediate gallium nitride (GaN) channel layer and at least one intermediate p-doped gallium nitride (pGaN) layer arranged over the at least one intermediate aluminium gallium nitride (AlGaN) barrier layer respectively, wherein the at least one intermediate gallium nitride (GaN) barrier layer, the at least one intermediate aluminium gallium nitride (AlGaN) barrier layer and the at least one intermediate p-doped gallium nitride (pGaN) layer are arranged between the first gallium nitride (GaN) channel layer, the first aluminium gallium nitride (AlGaN) barrier layer, the first p-doped gallium nitride (pGaN) layer and the second gallium nitride (GaN) channel layer, the second aluminium gallium nitride (AlGaN) barrier layer, the second p-doped gallium nitride (pGaN) layer.

By virtue of using the at least one intermediate gallium nitride channel layer, the at least one intermediate aluminium gallium nitride barrier layer, and the at least one intermediate p-doped gallium nitride layer, the member achieves an improved reliability.

In yet another implementation form, the first gallium nitride (GaN) channel layer comprises an un-intentionally doped (UID) layer.

Beneficially, the aluminium gallium nitride layer of the gallium nitride buffer layer provides an improved electrical connection with the first aluminium gallium nitride barrier layer.

In another implementation form, at least one of the drain contact, the gate contact and/or the source contact is ohmic, Schottky and/or metal.

By virtue of using the ohmic, Schottky and/or metal, an improved electrical connection is obtained through the gate contact, the source contact, and the drain contact of the member.

In another aspect, the present disclosure provides a metal-semiconductor field-effect transistor (MESFET) device comprising a member.

The metal-semiconductor field-effect transistor (MESFET) device achieves all the advantages and technical effects of the member of the present disclosure.

In yet another aspect, the present disclosure provides a power device comprising the member.

The power device achieves all the advantages and technical effects of the member of the present disclosure.

In another aspect, the present disclosure provides a method for manufacturing a member, where the method is not part of the claimed invention, wherein the method comprises arranging a gallium nitride (GaN) buffer layer arranged over a transition layer arranged over a silicon base substrate layer, arranging a first aluminium gallium nitride (AlGaN) barrier layer over the gallium nitride (GaN) buffer layer, arranging a first p-doped gallium nitride (pGaN) layer over the first aluminium gallium nitride (AlGaN) barrier layer, arranging a second gallium nitride (GaN) channel layer over the first pGaN layer, arranging a second aluminium gallium nitride (AlGaN) barrier layer over the second gallium nitride (GaN) channel layer, arranging a second p-doped gallium nitride (pGaN) layer over the second barrier aluminium gallium nitride (AlGaN) layer, arranging a gate contact over the second p-doped gallium nitride (pGaN) layer, arranging a source contact over the first aluminium gallium nitride (AlGaN) layer, arranging a drain contact over the first aluminium gallium nitride (AlGaN) layer, arranging a sacrificial passivation layer over the p-doped gallium nitride (pGaN) layer, forming a space in the sacrificial passivation layer, the second p-doped gallium nitride (pGaN) layer, the second aluminium gallium nitride (AlGaN) barrier layer and the second gallium nitride (GaN) channel layer, and connecting the first p-doped gallium nitride (pGaN) layer with the second p-doped gallium nitride (pGaN) layer by arranging a connecting p-doped gallium nitride (pGaN) portion extending in the space.

The method achieves all the advantages and technical effects of the member of the present disclosure.

It is to be appreciated that all the aforementioned implementation forms can be combined. It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof, where these methods are not part of the claimed invention. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

### BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein, where the methods are not part of the claimed invention. Moreover, those in the art will understand that the drawings are not to scale. Wherever possible, like elements have been indicated by identical numbers.

Embodiments of the present disclosure will now be described, by way of example only, with reference to the following diagrams wherein:
FIGs. 1A and 1B are schematic illustrations of a member, in accordance with different embodiments of the present disclosure;
FIG. 2A is a schematic illustration of a member, in accordance with another embodiment of the present disclosure;
FIG. 2B is a schematic illustration of a member, in accordance with yet another embodiment of the present disclosure;
FIG. 2C is a schematic illustration of a member, in accordance with another embodiment of the present disclosure;
FIG. 2D is a schematic illustration of a member, in accordance with yet another embodiment of the present disclosure;
FIG. 2E is a schematic illustration of a member, in accordance with another embodiment of the present disclosure;
FIG. 2F is a schematic illustration of a member, in accordance with yet another embodiment of the present disclosure;
FIG. 2G is a schematic illustration of a member, in accordance with another embodiment of the present disclosure;
FIG. 3 is a schematic illustration of a member, in accordance with another embodiment of the present disclosure;
FIG. 4 is a schematic illustration of a member, in accordance with yet another embodiment of the present disclosure;
FIG. 5 is a schematic illustration of a member, in accordance with another embodiment of the present disclosure;
FIG. 6 is a flowchart of an exemplary method for an exemplary manufacturing a member, in accordance with an embodiment of the present disclosure, where the method is not part of the claimed invention;
FIG. 7A is a graphical representation that illustrates an electric field cut along a direction of a gallium nitride channel layer within an aluminium gallium nitride barrier layer, during off-state conditions, in accordance with an embodiment of the present disclosure;
FIG. 7B is a graphical representation that illustrates an electric field cut along a direction of a gallium nitride channel layer within an aluminium gallium nitride barrier layer, during off-state conditions, for different p-type doping degree in the p-doped gallium nitride layer, in accordance with an embodiment of the present disclosure;
FIG. 8 is a block diagram of a metal-semiconductor field-effect transistor (MESFET) device, in accordance with an embodiment of the present disclosure; and
FIG. 9 is a block diagram of a power device, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

### DETAILED DESCRIPTION OF EMBODIMENTS

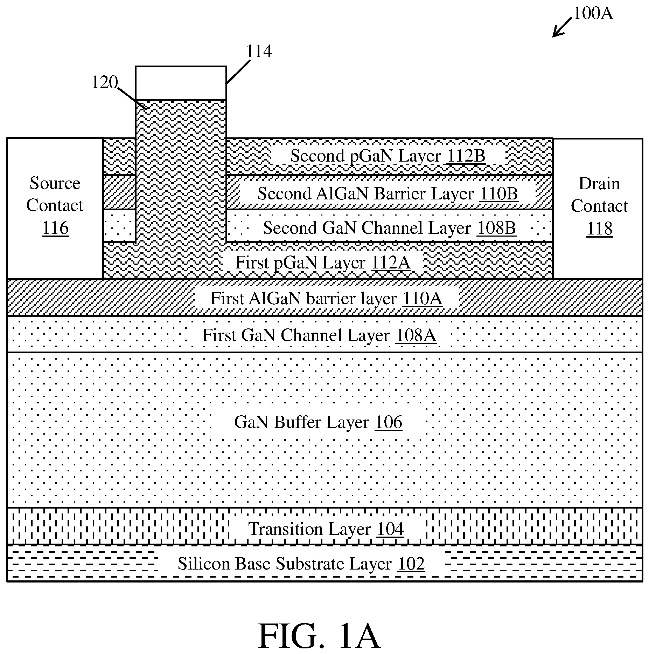

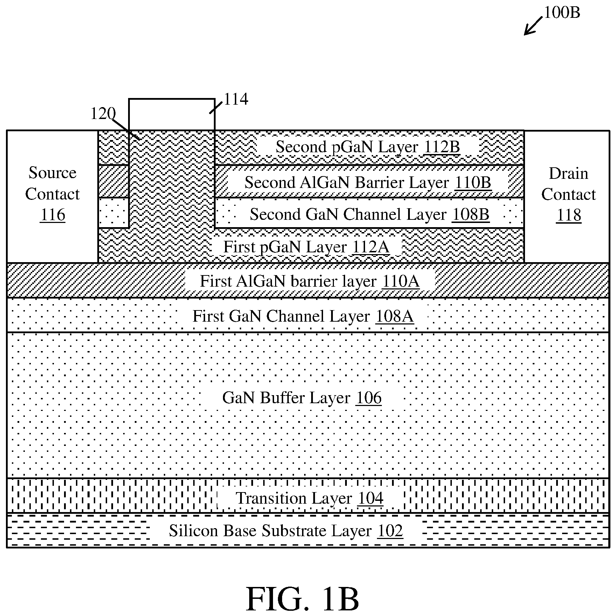

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible. FIGs. 1A and 1B are schematic illustrations of a member, in accordance with different embodiments of the present disclosure. With reference to FIGs. 1A and 1B, there is shown a schematic illustration of a member, such as a member **100A** (of FIG.1A) and a member **100B** (of FIG. 1B), each of which includes a silicon base substrate layer **102,** a transition layer **104,** a gallium nitride (GaN) buffer layer **106,** a first gallium nitride (GaN) channel layer **108A,** and a second gallium nitride (GaN) channel layer **108B.** There is further shown a first aluminium gallium nitride (AlGaN) barrier layer **110A,** a second aluminium gallium nitride (AlGaN) barrier layer **110B,** a first p-doped gallium nitride (pGaN) layer **112A,** and a second p-doped gallium nitride (pGaN) layer **112B.** There is further shown a gate contact **114,** a source contact **116,** a drain contact **118,** and a connecting p-doped gallium nitride (pGaN) portion **120.**

In the following, layer 108B is referred to as second gallium nitride (GaN) channel layer in view of a two-dimensional electron gas at an interface between the second aluminium gallium nitride (AlGaN) barrier layer (110B) and the second gallium nitride (GaN) channel layer, although layer 108B does not act as channel layer.

The member **100A** is a semiconductor structure that includes one or more layers of semiconductor material. In an example, the semiconductor material of one layer may be the same (or different) as compared to the semiconductor material of another layer. The member **100A** may also comprise layers or structures of materials other than the semiconductor materials. Further, the member **100A** may constitute a semiconductor device or be comprised in the semiconductor device. The semiconductor structure of the member **100A** of FIG. 1A is same as that of FIG. 1B, however in the member **100B,** there is a slight difference in terms of arrangement of the second p-doped gallium nitride layers **112B,** which does not protrude above an upper surface of the second p-doped gallium nitride layer **112B.** The silicon base substrate layer **102** is a thin slice of semiconductor material, which may also be referred to as a single wafer or a chip. The silicon base substrate layer **102** acts as a base of the member **100A.** Due to its abundant availability, the silicon base substrate layer **102** is a low-cost material. The silicon base substrate layer **102** is available in different sizes, such as a size of six-inch (6"), eight-inch (8"), and twelve-inch (12").

The transition layer **104** is a layer of a material (e.g., compositionally graded material), which is used to provide sufficient strain relief, and to limit or prevent the formation of cracks in the gallium nitride buffer layer **106.**

The gallium nitride buffer layer **106** is a layer of gallium nitride semiconductor material, which is a wide-bandgap (WBG) semiconductor material. The bandgap of the gallium nitride buffer layer **106** is of a value of 3.4 electron volt (eV). In an example, the gallium nitride buffer layer **106** is doped with dopant elements (e.g., carbon or iron). Moreover, such dopant elements act as a p-type doping and effectively increase the breakdown strength of the first epitaxial stack (or epitaxial layer) as well as it contributes to a significant decrease in the lateral parasitic leakage current.

The first gallium nitride channel layer **108A,** and the second gallium nitride channel layer **108B** are the layers of gallium nitride semiconductor material.

The first aluminium gallium nitride barrier layer **110A,** and the second aluminium gallium nitride barrier layer **110B** are the layers of a semiconductor material. In an example, the first aluminium gallium nitride barrier layer **110A,** and the second aluminium gallium nitride barrier layer **110B** acts as a barrier layer.

The first p-doped gallium nitride layer **112A** and the second p-doped gallium nitride (pGaN) layer **112B** are the layers of gallium nitride semiconductor material p-type dopants (e.g., magnesium (Mg)). Similarly, the connecting p-doped gallium nitride (pGaN) portion **120** is a layer of gallium nitride semiconductor material p-type dopants, and which acts as a connecting layer.

The gate contact **114,** the source contact **116,** and the drain contact **118** correspond to a metal gate contact, a metal source contact, and a metal drain contact terminal of a semiconductor device. The gate contact **114,** the source contact **116,** and the drain contact **118** are used for connection purposes (e.g., to connect the semiconductor device to a power supply).

In one aspect, the present disclosure provides the member **100A** that comprises, the silicon base substrate layer **102,** the transition layer **104** arranged over the silicon base substrate layer **102,** the gallium nitride (GaN) buffer layer **106** arranged over the transition layer **104.** In other words, the silicon base substrate layer **102** of the member **100A** acts as a base of the member **100A.** Further, the transition layer **104** is arranged over the silicon base substrate layer **102,** where the transition layer **104** is in direct contact with the silicon base substrate layer **102.** In an example, there are two possible approaches for the composition of the transition layer **104,** such as a graded buffer approach, and a superlattice approach. In the graded buffer approach, the transition layer **104** is composed of an aluminium nitride (AIN) layer (or a nucleation layer). For example, the aluminium nitride layer is directly arranged on top of the silicon base substrate layer **102,** followed by a sequence of aluminium gallium nitride (AlGaN) layers (e.g., three or more layers), where the content of aluminium in the aluminium nitride layer is decreasing gradually from 100% to 0. Instead, in the superlattice approach, the aluminium nitride layer (or a nucleation layer) is directly arranged on top of the silicon base substrate layer **102,** followed by a superlattice, where the superlattice is composed of a stack of aluminium nitride/aluminium gallium nitride (AIN/AlGaN) layers, and the superlattice is repeated several times (e.g., from 30 times to 100 times). Thereafter, the member **100A** further includes the gallium nitride buffer layer **106** arranged on the transition layer **104.** In other words, the gallium nitride buffer layer **106** is arranged on the silicon base substrate layer **102,** such as to form a GaN-On-Si substrate, as shown in FIG. 1A. Beneficially, the transition layer **104** provides sufficient strain relief and also limits (or prevents) the formation of cracks in the gallium nitride buffer layer **106.**

The member **100A** further comprises the first aluminium gallium nitride (AlGaN) barrier layer **110A** arranged over the gallium nitride (GaN) buffer layer **106.** The first p-doped gallium nitride (pGaN) layer **112A** is arranged over the first aluminium gallium nitride (AlGaN) barrier layer **110A,** where a portion of the gallium nitride (GaN) buffer layer 106 forms a first gallium nitride (GaN) channel layer **108A.** The first gallium nitride (GaN) channel layer **108A,** the first aluminium gallium nitride (AlGaN) barrier layer **110A** and the first p-doped gallium nitride (pGaN) layer **112A** forms the first epitaxial stack. In other words, the member **100A** includes the first epitaxial stack, which is formed from three different layers, such as the first gallium nitride channel layer **108A,** the first aluminium gallium nitride barrier layer **110A** and the first p-doped gallium nitride layer **112A.** As, the first gallium nitride channel layer **108A** is formed from the portion of the gallium nitride buffer layer **106,** thus the first gallium nitride channel layer **108A** is in direct contact with the gallium nitride buffer layer **106.** Moreover, the member **100A** makes use of the properties of the gallium nitride buffer layer **106** to achieve improved electrical performance, for example, breakdown voltage (BV) for different semiconductor devices. The member **100A** provides a new device concept that makes use of a stacked-layer approach, and as well as the use of p-type doped gallium nitride, such as the first p-doped gallium nitride layer **112A.** In an example, the member **100A** provides a contemporary use of a two-dimensional electron gas (2DEG) that forms at an interface between the first aluminium gallium nitride barrier layer **110A,** and the first gallium nitride channel layer **108A.** In an example, the two-dimensional electron gas is a scientific model in solid-state physics, where the two-dimensional electron gas is free to move in two dimensions, but tightly confined in a third dimension. Moreover, such tight confinement leads to quantized energy levels for a motion of the two-dimensional electron gas in the third dimension, which can then be ignored for most problems. Thus, the two-dimensional electron gas appears to be a two-dimensional (2D) sheet embedded in a three-dimensional (3D) world. Beneficially, by virtue of using the two-dimensional electron gas, the member **100A** is less prone to dynamic effects due to surface defects, and also to thickness variation caused by process variations (e.g., etching of p-doped gallium nitride). The two-dimensional electron gas has high mobility. Moreover, due to the quantum confinement and reduced intervalley scattering the carrier mobility increases. Moreover, due to the presence of the two-dimensional electron gas, a channel is not formed at an oxide/semiconductor interface of the member **100A,** as formed in conventional metal oxide silicon field effect transistor (or MOSFET), but rather formed at a semiconductor/semiconductor interface. This, also increases the mobility of the two-dimensional electron gas. In addition, the reduced sensitivity to surface effects and better dynamic behavior is one of the advantages of the member **100A** as compared with state of the art.

The member **100A** further comprises the second gallium nitride (GaN) channel layer **108B** arranged over the first p-doped gallium nitride (pGaN) layer **112A,** the second aluminium gallium nitride (AlGaN) barrier layer **110B** arranged over the second gallium nitride (GaN) channel layer **108B,** and the second p-doped gallium nitride (pGaN) layer **112B** arranged over the second aluminium gallium nitride (AlGaN) barrier layer **110B.** The member **100A** further includes three other layers, which are formed on the first epitaxial stack. In other words, a second epitaxial stack is formed above the first second epitaxial stack, such as the second epitaxial stack includes the second gallium nitride channel layer **108B,** the second aluminium gallium nitride barrier layer **110B,** and the second p-doped gallium nitride layer **112B.** The second gallium nitride channel layer **108B** is arranged over the first p-doped gallium nitride layer **112A,** the second aluminium gallium nitride barrier layer **110B** is arranged over the second gallium nitride channel layer **108B,** and the second p-doped gallium nitride layer **112B** is arranged over the second aluminium gallium nitride barrier layer **110B.** Like the first epitaxial stack, the member **100A** provides the contemporary use of the two-dimensional electron gas that forms at an interface between the second aluminium gallium nitride barrier layer **110B,** and the second gallium nitride channel layer **108B.** As a result, the member **100A** achieves enhanced capability for high voltage operation.

The member **100A** further comprises the gate contact **114** arranged over the second p-doped gallium nitride (pGaN) layer **112B,** the source contact **116** arranged over the first aluminium gallium nitride (AlGaN) barrier layer **110A,** and the drain contact **118** arranged over the first aluminium gallium nitride (AlGaN) barrier layer **110A.** The second p-doped gallium nitride (pGaN) layer **112B** is connected to the first p-doped gallium nitride (pGaN) layer **112A** by the connecting p-doped gallium nitride (pGaN) portion **120** extending through a space in the second aluminium gallium nitride (AlGaN) barrier layer **110B** and the second gallium nitride (GaN) channel layer **108B.** Moreover, the first p-doped gallium nitride (pGaN) layer **112A** is arranged between the source contact **116** and the drain contact **118.** In other words, the member **100A** further includes the space formed (e.g., via etching) in the second p-doped gallium nitride (pGaN) layer **112B,** the second aluminium gallium nitride barrier layer **110B,** the second gallium nitride channel layer **108B,** and the first p-doped gallium nitride (pGaN) layer **112A.** The member **100A** further includes the connecting p-doped gallium nitride portion **120,** which extends through the space, so as to connect the second p-doped gallium nitride layer **112B** to the first p-doped gallium nitride layer **112A.** In an example, a recess is arranged (e.g., via etching) at each end of the member **100A,** such as at a left end as well as at a right end of the member **100A.** As a result, the first aluminium gallium nitride barrier layer **110A** is exposed from a top view of the member **100A** (e.g., exposed or visible at both ends of the member **100A),** and through the recess that is formed at both ends of the member **100A.** Thereafter, the source contact **116,** and the drain contact **118** are arranged at two opposite ends of the first aluminium gallium nitride barrier layer **110A.** For example, the source contact **116** is arranged at the left end of the first aluminium gallium nitride barrier layer **110A,** and the drain contact **118** is arranged at the right end of the first aluminium gallium nitride barrier layer **110A,** as shown in FIG.1A. As a result, the first p-doped gallium nitride layer **112A** is arranged between the source contact **116** and the drain contact **118.** In addition, the gate contact **114** is arranged over the second p-doped gallium nitride layer **112B.** The gate contact is arranged over the connecting p-doped gallium nitride portion **120,** which is beneficial to deplete a two-dimensional electron gas below the gate contact **114** and also to allow a normally off device operation of the member **100A.**

In an implementation, the recess is formed at both ends of the member **100A** in order to etch away completely the first aluminium gallium nitride barrier layer **110A.** Since the first aluminium gallium nitride barrier layer **110A** has been removed completely, thus, the gallium nitride buffer layer **106** will be exposed though the recess. Thereafter, the source contact **116** is arranged at the left end of the gallium nitride buffer layer **106,** and the drain contact **118** is arranged at the right end of the gallium nitride buffer layer **106.** Thus, the resulted member would look exactly the same as that of the member **100A** of the FIG. 1A or the member **100B** of the FIG. 1B with the exception that the source contact **116,** and the drain contact **118** are now in direct contact with the gallium nitride buffer layer **106.** The member **100A** enables a drastic (or massive) reduction in an electric field peak at an edge of the gate contact **114** and the drain contact **118** (or at gate-drain edge). Moreover, by use of the second aluminium gallium nitride barrier layer **110B,** a flat electric field distribution is achieved along the first aluminium gallium nitride barrier layer **110A** and the second aluminium gallium nitride barrier layer **110B.** In addition, the member **100A** achieves an improved breakdown voltage (BV), which allows to have a drastic reduction in dimensions of a semiconductor device (e.g., a transistor device, a power device) for the same target breakdown voltage. In addition, the member **100A** is beneficial to improve the reliability (or high-temperature reverse bias (HTRB) reliability) of the semiconductor device without sacrificing the overall performance of the semiconductor device.

In accordance with an embodiment, the gate contact **114** is arranged over the connecting p-doped gallium nitride (pGaN) portion **120.** As the connecting p-doped gallium nitride portion **120** connects the first p-doped gallium nitride layer **112A** and the second p-doped gallium nitride layer **112B.** Therefore, the gate contact **114** arranged over the connecting p-doped gallium nitride portion **120** is also in direct contact with the first p-doped gallium nitride layer **112A** and the second p-doped gallium nitride layer **112B.** Beneficially, there is a minimum resistance between the gate contact **114** and the first p-doped gallium nitride layer **112A.**

In accordance with an embodiment, the connecting p-doped gallium nitride (pGaN) portion **120** connecting the first p-doped gallium nitride (pGaN) layer **112A** and the second p-doped gallium nitride (pGaN) layer **112B** is arranged to extend above an upper surface of the second p-doped gallium nitride (pGaN) layer **112B.** In other words, the connecting p-doped gallium nitride portion **120** is configured to connect the first p-doped gallium nitride layer **112A** and the second p-doped gallium nitride layer **112B.** In an example, the connecting p-doped gallium nitride portion **120** extend (or as in protrude) above the upper surface of the second p-doped gallium nitride layer **112B.** As a result, the gate contact **114** arranged over the connecting p-doped gallium nitride (pGaN) portion **120,** will be an extended gate contact.

In an implementation, the connecting p-doped gallium nitride portion **120** is arranged above the upper surface of the second p-doped gallium nitride (pGaN) layer **112B,** but doesn't extend above the upper surface of the second p-doped gallium nitride layer **112B** (as further shown in FIG. 1B). As a result, the gate contact **114** arranged over the connecting p-doped gallium nitride portion **120** can be used for further electrical connection with an external supply.

In accordance with an embodiment, the first gallium nitride (GaN) channel layer **108A** has a first gallium nitride (GaN) channel layer thickness, and the first aluminium gallium nitride (AlGaN) barrier layer **110A** has a first aluminium gallium nitride (AlGaN) barrier layer thickness. Similarly, the first p-doped gallium nitride (pGaN) layer **112A** also has a first p-doped gallium nitride (pGaN) layer thickness. Similarly, the second gallium nitride (GaN) channel layer **108B** has a second gallium nitride (GaN) channel layer thickness, and the second aluminium gallium nitride (AlGaN) barrier layer **110B** has a second aluminium gallium nitride (AlGaN) barrier layer thickness. The second p-doped gallium nitride (pGaN) layer **112B** also has a second p-doped gallium nitride (pGaN) layer thickness. The second gallium nitride (GaN) channel layer thickness equals the first gallium nitride (GaN) channel layer thickness.The second aluminium gallium nitride (AlGaN) barrier layer thickness equals the first aluminium gallium nitride (AlGaN) barrier layer thickness and/or the second p-doped gallium nitride (pGaN) layer thickness equals the first p-doped gallium nitride (pGaN) layer thickness. In other words, the thickness of a layer of the first epitaxial stack is equal to the thickness of a corresponding layer of the second epitaxial stack. For example, the thickness of the first gallium nitride channel layer **108A** is equal to the thickness of the second gallium nitride channel layer **108B,** and the thickness of the first aluminium gallium nitride barrier layer **110A** is equal to the thickness of the second aluminium gallium nitride barrier layer **110B,** and the like. Alternatively stated, different layers of the first epitaxial stack are of same thickness as that of the corresponding layers of the second epitaxial stack. By virtue of using the same thickness for the different layers of the first epitaxial stack as well as for the different layers of the second epitaxial stack, the overall performance, as well as reliability of the member **100A,** is improved. Moreover, an overall cost of production of the member **100A** is reduced.

In accordance with an embodiment, the first gallium nitride (GaN) channel layer **108A** has a first gallium nitride (GaN) channel layer thickness, and the first aluminium gallium nitride (AlGaN) barrier layer **110A** has a first aluminium gallium nitride (AlGaN) barrier layer thickness. Similarly, the first p-doped gallium nitride (pGaN) layer **112A** also has a first p-doped gallium nitride (pGaN) layer thickness. The second gallium nitride (GaN) channel layer **108B** has a second gallium nitride (GaN) channel layer thickness, and the second aluminium gallium nitride (AlGaN) barrier layer **110B** has a second aluminium gallium nitride (AlGaN) barrier layer thickness. Similarly, the second p-doped gallium nitride (pGaN) layer **112B** also has a second p-doped gallium nitride (pGaN) layer thickness. The second gallium nitride (GaN) channel layer thickness differs from the first gallium nitride (GaN) channel layer thickness. The second aluminium gallium nitride (AlGaN) barrier layer thickness differs from the first aluminium gallium nitride (AlGaN) barrier layer thickness, and the second p-doped gallium nitride (pGaN) layer thickness differs from the first p-doped gallium nitride (pGaN) layer thickness. In other words, the thickness of a layer of the first epitaxial stack is different from the thickness of a corresponding layer of the second epitaxial stack. Alternatively stated, different layers of the first epitaxial stack are of different thicknesses as compared to the thickness of the corresponding layers in the second epitaxial stack. Therefore, the thickness of the different layers of the first epitaxial stack as well as for the second epitaxial stack can be manipulated, so that the member **100A** can achieve a desired performance as well as a desired reliability.

In accordance with an embodiment, the first gallium nitride (GaN) channel layer thickness is in the range, the first aluminium gallium nitride (AlGaN) barrier layer thickness is in the range, and the first p-doped gallium nitride (pGaN) layer thickness is in the range. The second gallium nitride (GaN) channel layer thickness is in the range, the second aluminium gallium nitride (AlGaN) barrier layer thickness is in the range, and/or the second p-doped gallium nitride (pGaN) layer thickness is in the range. In other words, the thickness of a layer of the first epitaxial stack is alternative to the thickness of a corresponding layer of the second epitaxial stack. For example, the first gallium nitride channel layer thickness ranges between 100 nanometre (nm) to 500 nm, while the second gallium nitride channel layer thickness ranges between 10 nm to 200 nm. Similarly, the first aluminium gallium nitride barrier layer thickness ranges between 10 nm to 30 nm, while the second aluminium gallium nitride barrier layer thickness ranges between 10 nm to 30 nm. Moreover, the first p-doped gallium nitride layer thickness, as well as the second p-doped gallium nitride layer thickness, ranges between 5 nm to 100 nm. In an example, the connecting p-doped gallium nitride portion **120** also has a thickness that ranges between 60 nm and 500 nm.

In an implementation, a thinner layer is beneficial to improve the performance of the member **100A,** and a thicker layer is beneficial to improve the reliability of the member **100A.** Therefore, by virtue of using alternative thickness for different layers, the member **100A** can achieve either the desired performance and the desired reliability.

In accordance with an embodiment, the first gallium nitride (GaN) channel layer **108A** has a doping degree in the range, the first aluminium gallium nitride (AlGaN) barrier layer has a doping degree in the range, and the first p-doped gallium nitride (pGaN) layer has a doping degree in the range. The second gallium nitride (GaN) channel layer has a doping degree in the range, the second aluminium gallium nitride (AlGaN) barrier layer has a doping degree in the range, and/or the second p-doped gallium nitride (pGaN) layer has a doping degree in the range. In other words, each layer of the first epitaxial stack as well as of the second epitaxial stack has the range of the doping degree. For example, the doping degree for the first aluminium gallium nitride barrier layer **110A** as well as for the second aluminium gallium nitride barrier layer **110B** has an aluminium content between 15% and 25%. Similarly, the doping degree for the first p-doped gallium nitride layer **112A** as well as for the second p-doped gallium nitride layer **112B** has a p-type concentration between 1e¹⁷ cubic centimetres (cm⁻³) and 5e¹⁸ cm⁻³. In an example, the first p-doped gallium nitride layer **112A** as well as for the second p-doped gallium nitride layer **112B** is doped via magnesium (Mg). In an example, the connecting p-doped gallium nitride portion **120** also has a doping degree that ranges between 1e¹⁸ cm⁻³ and 5e¹⁹ cm⁻³. In an implementation, a high doping degree is beneficial to improve the performance of the member **100A,** and a lower doping degree is beneficial to improve the reliability of the member **100A.** Therefore, the doping degree can be adjusted for different layers of the member **100A,** so that the member **100A** can achieve the desired performance as well as the desired reliability.

In an implementation, as the doping degree (and thickness) is increased (e.g., up to a certain point) for the first p-doped gallium nitride layer **112A** as well as for the second p-doped gallium nitride layer **112B,** the electric field in the member **100** is reduced. As a result, the overall reliability of the member **100A** is improved. Therefore, the doping degree (and thickness) can be manipulated for the first p-doped gallium nitride layer **112A** as well as for the second p-doped gallium nitride layer **112B,** so that the member **100A** can achieve either the desired performance (figure of merits) or the desired reliability.

In accordance with an embodiment, the first gallium nitride (GaN) channel layer **108A** comprises an un-intentionally doped (UID) layer. In an implementation, the gallium nitride un-intentionally doped layer (UID) is a portion or the totality of the first gallium nitride (GaN) channel layer **108A** that is not intentionally doped with dopants elements (n-type nor p-type). Moreover, the gallium nitride buffer layer **106** is doped with carbon or iron (i.e., with p-type dopant) to increase the breakdown strength of the gallium nitride buffer layer **106.**

In accordance with an embodiment, at least one of the drain contact **118,** the gate contact **114** and/or the source contact **116** is ohmic, and/or Schottky. As the gate contact **114,** the source contact **116,** and the drain contact **118** are used for current flow and for further electrical connection purposes. Therefore, by virtue of using the ohmic, Schottky and/or metal, an improved electrical connection is obtained through the gate contact **114,** the source contact **116,** and the drain contact **118** of the member **100A.**

The member **100A** enables drastic reduction in an electric field peak at an edge of the gate contact **114** and the drain contact **118** (or at the gate-drain edge). Moreover, due to the use of the second aluminium gallium nitride barrier layer **110B,** a flat electric field distribution is achieved along the first aluminium gallium nitride barrier layer **110A,** and the second aluminium gallium nitride barrier layer **110B** of the member **100A.** The member **100A** further achieves an improved breakdown voltage (BV), which in turn allows to have a drastic reduction in dimensions of the semiconductor device for the same target breakdown voltage. In addition, the first epitaxial stack and the second epitaxial stack of the member **100A** are beneficial to improve the performance as well as reliability of the member **100A.** The member **100A** is also beneficial to improve the reliability of a semiconductor device without sacrificing the overall performance of the semiconductor device and manifests an enhanced high voltage operation capability.

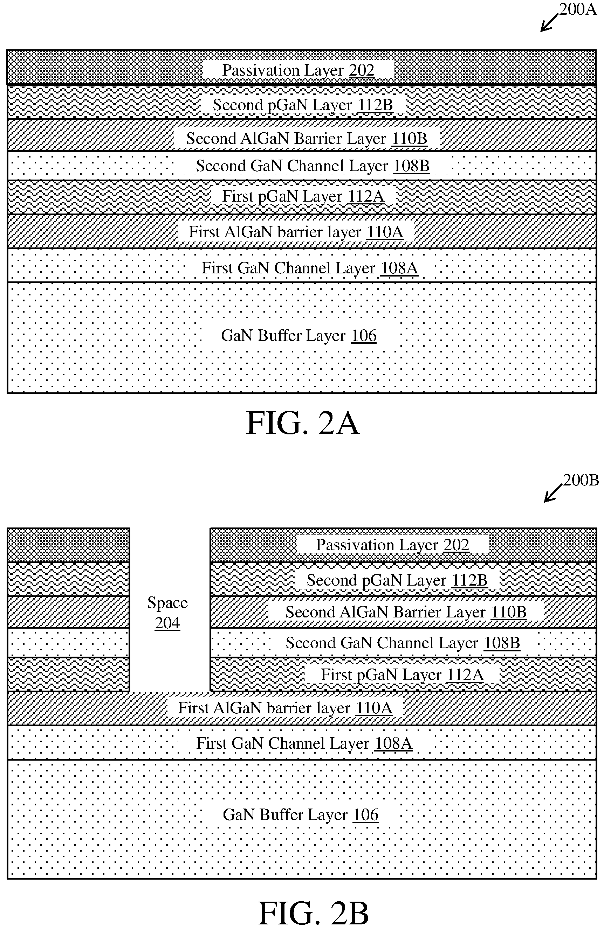

FIG. 2A is a schematic illustration of a member, in accordance with another embodiment of the present disclosure. FIG. 2A is described in conjunction with elements from the FIGs. 1A and 1B. With reference to FIG. 2A, there is shown a schematic illustration of a member **200A** that includes a passivation layer **202,** the gallium nitride buffer layer **106,** the first gallium nitride channel layer **108A,** and the second gallium nitride channel layer **108B.** The member **200A** further includes the first aluminium gallium nitride barrier layer **110A,** the second aluminium gallium nitride barrier layer **110B,** the first p-doped gallium nitride layer **112A,** and the second p-doped gallium nitride layer **112B.**

The passivation layer **202** is configured to prevent oxidation of the second p-doped gallium nitride layer **112B.** Examples of the passivation layer **202** include, but are not limited to, the aluminium oxide, aluminium nitride, silicon dioxide, the silicon nitride, and the like. The passivation layer **202** is intended to avoid regrowth of the connecting p-doped gallium nitride portion **120** on top of the second p-doped gallium nitride layer **112B** (or subsequent p-doped gallium nitride layer, and the like). Moreover, in the absence of the passivation layer **202,** the regrowth of the connecting p-doped gallium nitride portion **120** may be everywhere and not limited only to the region inside the trench.

In accordance with an embodiment, the member **200A** further comprises a passivation layer **202** arranged over the second p-doped gallium nitride (pGaN) layer **112B** and the connecting p-doped gallium nitride (pGaN) portion **120** extends through in the passivation layer **202.** In other words, the member **200A** includes the passivation layer **202** that is arranged over the second p-doped gallium nitride layer 11B, which further results in the formation of a passivated p-doped gallium nitride. The passivation layer **202** is beneficial to prevent oxidation of the second p-doped gallium nitride layer **112B.**

FIG. 2B is a schematic illustration of a member, in accordance with yet another embodiment of the present disclosure. FIG. 2B is described in conjunction with elements from the FIGs. 1A, 1B and 2A. With reference to FIG. 2B, there is shown a schematic illustration of a member **200B** that includes a space **204,** the gallium nitride buffer layer **106,** the first gallium nitride channel layer **108A,** and the second gallium nitride channel layer **108B.** The member **200B** further includes the first aluminium gallium nitride barrier layer **110A,** the second aluminium gallium nitride barrier layer **110B,** the first p-doped gallium nitride layer **112A,** the second p-doped gallium nitride layer **112B,** and the passivation layer **202.**

The space **204** may also be referred to as a trench, an opening, or a hole. In an example, the space **204** is formed via lithography etching, photolithography, or e-beam lithography.

In an implementation, the passivation layer **202** is initially deposited over the second p-doped gallium nitride layer **112B.** Thereafter, the passivation layer **110** is removed from one point along with the passivation layer **110,** the second p-doped gallium nitride layer **112B,** the second aluminium gallium nitride barrier layer **110B,** the second gallium nitride channel layer **108B,** and the first p-doped gallium nitride layer **112A.** As a result, the space **204** is defined within the member **200B.** Moreover, the first p-doped gallium nitride layer **112A** is exposed through the space **204,** as shown in FIG.2B. The space **204** is beneficial for a selective arrangement of the connecting p-doped gallium nitride portion **120.**

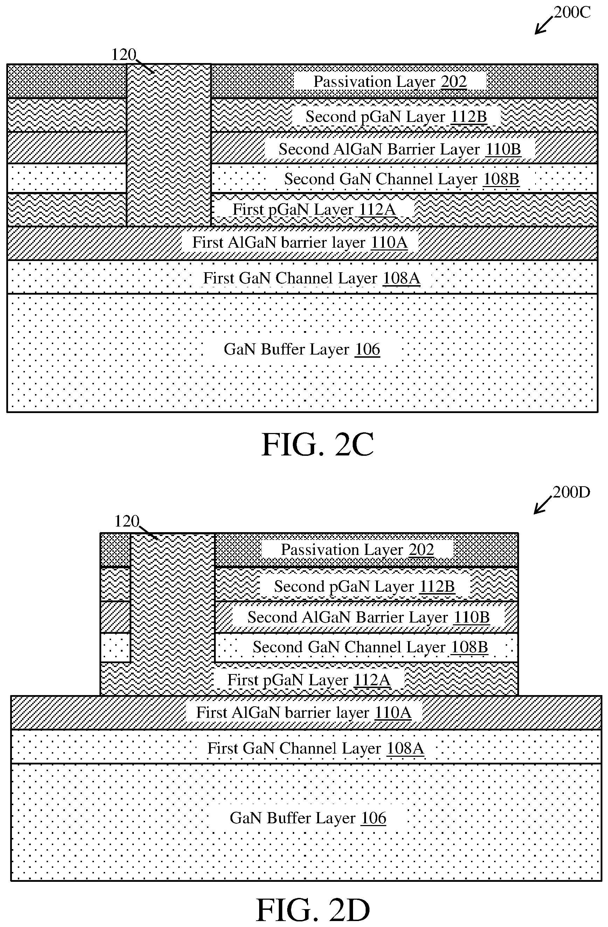

FIG. 2C is a schematic illustration of a member, in accordance with another embodiment of the present disclosure. FIG. 2C is described in conjunction with elements from the FIGs. 1A, 1B, 2A and 2B. With reference to FIG. 2C, there is shown a schematic illustration of a member **200C** that includes the gallium nitride buffer layer **106,** the first gallium nitride channel layer **108A,** and the second gallium nitride channel layer **108B.** The member **200C** further includes the first aluminium gallium nitride barrier layer **110A,** the second aluminium gallium nitride barrier layer **110B,** the first p-doped gallium nitride layer **112A,** the second p-doped gallium nitride layer **112B,** and the passivation layer **202.**

In accordance with an embodiment, the connecting p-doped gallium nitride (pGaN) portion **120** extends through in the passivation layer **202.** In an example, the passivation layer **202** is removed vertically from one point along with other layers of the member **200C.** As a result, the space **204** is defined on the passivation layer **202,** the second p-doped gallium nitride layer **112B,** the second aluminium gallium nitride barrier layer **110B,** and the second gallium nitride channel layer **108B.** Thereafter, the connecting p-doped gallium nitride portion **120** is arranged in the space **204** and also over the first p-doped gallium nitride layer **112A,** as shown in FIG. 2C. Therefore, selective placement of the connecting p-doped gallium nitride portion **120** is performed on the first aluminium gallium nitride buffer layer **110A** that extends up to the surface. Moreover, the connecting p-doped gallium nitride portion **120** is in direct contact with the first p-doped gallium nitride layer **112A,** and also in contact with the second p-doped gallium nitride layer **112B.** In addition, the passivation layer **202** arranged near the connecting p-doped gallium nitride portion **120** is beneficial to prevent oxidation of the connecting p-doped gallium nitride portion **120.** The passivation layer **202** further avoids regrowth of the connecting p-doped gallium nitride portion **120** on top of the second p-doped gallium nitride layer **112B** (or subsequent p-doped gallium nitride layer, and the like).

FIG. 2D is a schematic illustration of a member, in accordance with yet another embodiment of the present disclosure. FIG. 2D is described in conjunction with elements from the FIGs. 1A, 1B, 2A, 2B and 2C. With reference to FIG. 2D, there is shown a schematic illustration of a member **200D** that includes the silicon base substrate layer **102** (not shown in FIG.2D), the transition layer **104** (not shown in FIG.2D), the gallium nitride buffer layer **106,** the first gallium nitride channel layer **108A,** and the second gallium nitride channel layer **108B.** The member **200D** further includes the first aluminium gallium nitride barrier layer **110A,** the second aluminium gallium nitride barrier layer **110B,** the first p-doped gallium nitride layer **112A,** the second p-doped gallium nitride layer **112B,** and the passivation layer **202.**

In an implementation, a recess is formed at each end of the member **200C** of FIG. 2C, such as at a left end, as well as at a right end, which results in the formation of the member **200D** of FIG. 2D. As a result, the first aluminium gallium nitride barrier layer **110A** is exposed from a top view of the member **200D,** and at both ends of the member **200D,** as shown in FIG. 2D. The exposed area of the first aluminium gallium nitride barrier layer **110A** is beneficial for a selective arrangement of metal contacts, such as the source contact **116** (of FIG. 1A and 1B), and the drain contact (of FIG. 1A and 1B).

In another implementation, the recess is formed at both ends of the member **200C** so as to etch away completely the first aluminium gallium nitride barrier layer **110A,** due to which the gallium nitride buffer layer **106** will be exposed though the recess. The exposed area of the gallium nitride buffer layer **106** is beneficial for a selective arrangement of metal contacts, such as the source contact **116** (of FIGs. 1A and 1B), and the drain contact (of FIGs. 1A and 1B) over the gallium nitride buffer layer **106.**

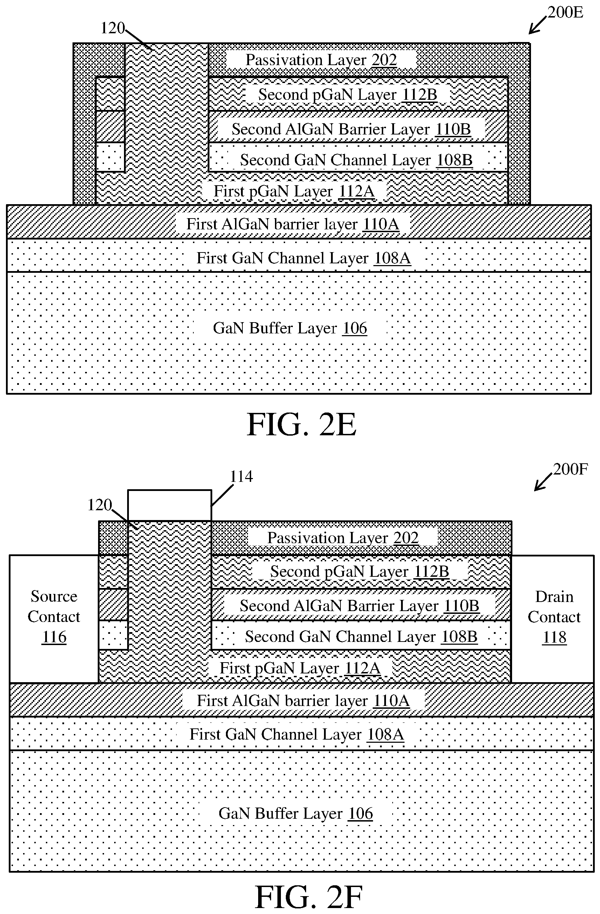

FIG. 2E is a schematic illustration of a member, in accordance with another embodiment of the present disclosure. FIG. 2E is described in conjunction with elements from the FIGs. 1A, 1B, 2A, 2B, 2C and 2D. With reference to FIG. 2E, there is shown a schematic illustration of a member **200E** that includes the gallium nitride buffer layer **106,** the first gallium nitride channel layer **108A,** and the second gallium nitride channel layer **108B.** The member **200E** further includes the first aluminium gallium nitride barrier layer **110A,** the second aluminium gallium nitride barrier layer **110B,** the first p-doped gallium nitride layer **112A,** the second p-doped gallium nitride layer **112B,** and the passivation layer **202.**

In an implementation, the passivation layer **202** is arranged at the top of the second p-doped gallium nitride layer **112B** of the member **200E.** In addition, the passivation layer **202** is also arranged at side surfaces (e.g., left side and right side) of the second p-doped gallium nitride layer **112B,** the second aluminium gallium nitride barrier layer **110B,** the second gallium nitride channel layer **108B,** and the first p-doped gallium nitride layer **112A.** Therefore, the passivation layer **202** arranged on the member **200E** is beneficial to prevent the oxidation of the second p-doped gallium nitride layer **112B** from the top as well as from both sides. The passivation layer **202** further prevent the oxidation of the side surfaces of the second aluminium gallium nitride barrier layer **110B,** the second gallium nitride channel layer **108B,** and the first p-doped gallium nitride layer **112A.** The passivation layer **202** further reduces any possible leakage paths from the stacked layers to the source contact **116** (or drain contact **118.**

FIG. 2F is a schematic illustration of a member, in accordance with yet another embodiment of the present disclosure. FIG. 2F is described in conjunction with elements from the FIGs. 1A, 1B, 2A, 2B, 2C, 2D and 2E. With reference to FIG. 2F, there is shown a schematic illustration of a member **200F** that includes the gallium nitride buffer layer **106,** the first gallium nitride channel layer **108A,** and the second gallium nitride channel layer **108B.** The member **200F** further includes the first aluminium gallium nitride barrier layer **110A,** the second aluminium gallium nitride barrier layer **110B,** the first p-doped gallium nitride layer **112A,** the second p-doped gallium nitride layer **112B,** and the passivation layer **202.** The member **200F** further includes the gate contact **114,** the source contact **116,** and the drain contact **118.** The member **200F** may also include the silicon base substrate layer **102** and the transition layer **104** (not shown in FIG.2F).

In an implementation, the source contact **116** is arranged on a left end of an exposed area of the first aluminium gallium nitride barrier layer **110A** (i.e., on the left end of the member **200D** of FIG. 2D). Moreover, the drain contact **118** is arranged on a right end of the exposed area of the first aluminium gallium nitride barrier layer **110A** (i.e., on a right end of the member **200D** of FIG. 2D). Furthermore, the gate contact **114** is arranged on the connecting p-doped gallium nitride portion **120** (i.e., of FIG. 2D). As a result, the member **200F** includes three metal contacts, such as the gate contact **114,** the source contact **116,** and the drain contact **118,** which are beneficial for further connection purposes (e.g., to provide supply to the member **200F).**

In an implementation, the source contact **116,** and the drain contact **118** form an ohmic contact with a two-dimensional electron gas, which is positioned at an interface between the first aluminium gallium nitride barrier layer **110A,** and the first gallium nitride channel layer **108A.** In addition, the source contact **116,** and the drain contact **118** are also laterally in contact with another two-dimensional electron gas (which is positioned at an interface between the second aluminium gallium nitride barrier layer **110B,** and the second gallium nitride channel layer **108B),** and with the second p-doped gallium nitride layer **112B.**

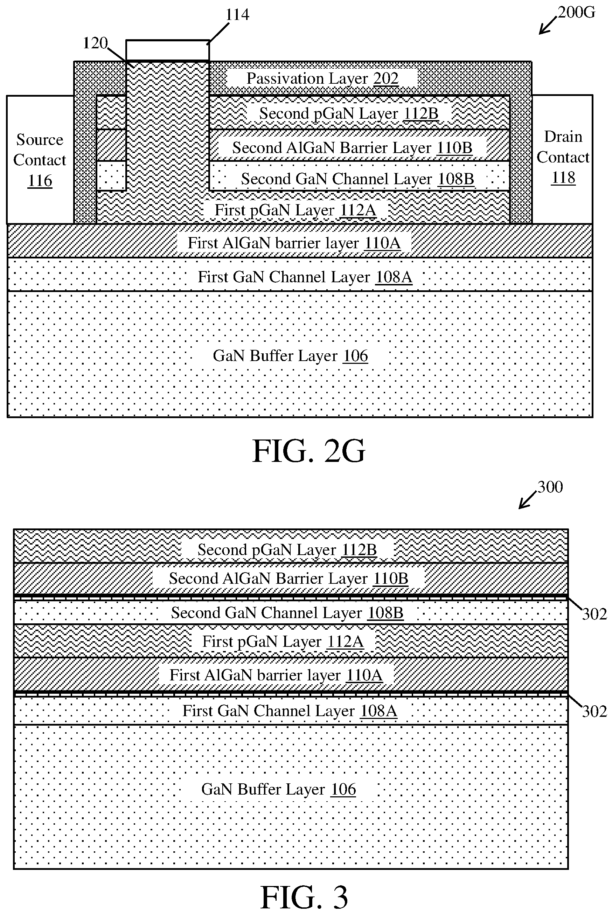

FIG. 2G is a schematic illustration of a member, in accordance with another embodiment of the present disclosure. FIG. 2G is described in conjunction with elements from the FIGs. 1A, 1B, 2A, 2B, 2C, 2D, 2E and 2F. With reference to FIG. 2G, there is shown a schematic illustration of a member **200G** that includes the gallium nitride buffer layer **106,** the first gallium nitride channel layer **108A,** and the second gallium nitride channel layer **108B.** The member **200G** further includes the first aluminium gallium nitride barrier layer **110A,** the second aluminium gallium nitride barrier layer **110B,** the first p-doped gallium nitride layer **112A,** the second p-doped gallium nitride layer **112B,** and the passivation layer **202.** The member **200G** further includes the gate contact **114,** the source contact **116,** and the drain contact **118.**

In accordance with an embodiment, the passivation layer **202** extends between the source contact **116** and the first p-doped gallium nitride (pGaN) layer **112A** and between the drain contact **118** and the first p-doped gallium nitride (pGaN) layer **112A.** In other words, the source contact **116** is arranged on a left end of an exposed area of the first aluminium gallium nitride barrier layer **110A** (i.e., on a left end of the member **200E** of FIG. 2E). Moreover, the drain contact **118** is arranged on a right end of the exposed area of the first aluminium gallium nitride barrier layer **110A** (i.e., on a right end of the member **200E** of FIG. 2E). Furthermore, the gate contact **114** is arranged on the connecting p-doped gallium nitride portion **120** (i.e., of FIG. 2E). As a result, the passivation layer **202** extends between the source contact **116** and the first p-doped gallium nitride layer **112A,** and also between the drain contact **118** and the first p-doped gallium nitride layer **112A** of the member **200G.** The passivation layer **202** is beneficial to provide lateral isolation between the source contact **116,** and the first p-doped gallium nitride layer **112A,** and also between the drain contact **118** and the first p-doped gallium nitride layer **112A.** Moreover, the passivation layer **202** reduces all possible leakage paths, especially at high voltage.

In accordance with an embodiment, the passivation layer **202** comprises aluminium oxide, aluminium nitride, silicon dioxide or silicon nitride. Therefore, the passivation layer **202** provides an improved isolation between the source contact **116** and the first p-doped gallium nitride layer **112A,** and also between the drain contact **118** and the first p-doped gallium nitride layer **112A.** In an example, the passivation layer **202** further provides isolation between the source contact **116** and the second p-doped gallium nitride layer **112B,** the second aluminium gallium nitride barrier layer **110B,** the second gallium nitride channel layer **108B,** along with the first p-doped gallium nitride layer **112A.** The passivation layer **202** further provides isolation between the drain contact **118** and the second p-doped gallium nitride layer **112B,** the second aluminium gallium nitride barrier layer **110B,** the second gallium nitride channel layer **108B,** along with the first p-doped gallium nitride layer **112A,** as shown in FIG. 2G.

FIG. 3 is a schematic illustration of a member, in accordance with another embodiment of the present disclosure. FIG. 3 is described in conjunction with elements from the FIGs. 1A, 1B, and 2A to 2G. With reference to FIG. 3, there is shown a schematic illustration of a member **300** that includes a two-dimensional electron gas (2DEG) **302.** The member **300** further includes the gallium nitride buffer layer **106,** the first gallium nitride channel layer **108A,** and the second gallium nitride channel layer **108B.** The member **300** further includes the first aluminium gallium nitride barrier layer **110A,** the second aluminium gallium nitride barrier layer **110B,** the first p-doped gallium nitride layer **112A,** and the second p-doped gallium nitride layer **112B.**

The two-dimensional electron gas **302** is a scientific model in solid-state physics, where the two-dimensional electron gas is free to move in two dimensions, but tightly confined in a third dimension. Moreover, such tight confinement leads to quantized energy levels for the motion of the two-dimensional electron gas in the third dimension, which can then be ignored for most problems. Thus, the two-dimensional electron gas appears to be a two-dimensional (2D) sheet embedded in a three-dimensional (3D) world.

In an implementation, the member **300** includes a contemporary use of the two-dimensional electron gas **302** that is formed at an interface between the first aluminium gallium nitride barrier layer **110A** and the first gallium nitride channel layer **108A.** In addition, two-dimensional electron gas **302** is also formed between the second aluminium gallium nitride barrier layer **110B,** and the second gallium nitride channel layer **108B.** Beneficially, by virtue of using the two-dimensional electron gas **302,** the member **300** is less prone to dynamic effects due to surface defects, and also to thickness variation caused by process variations (e.g., etching of p-doped gallium nitride).

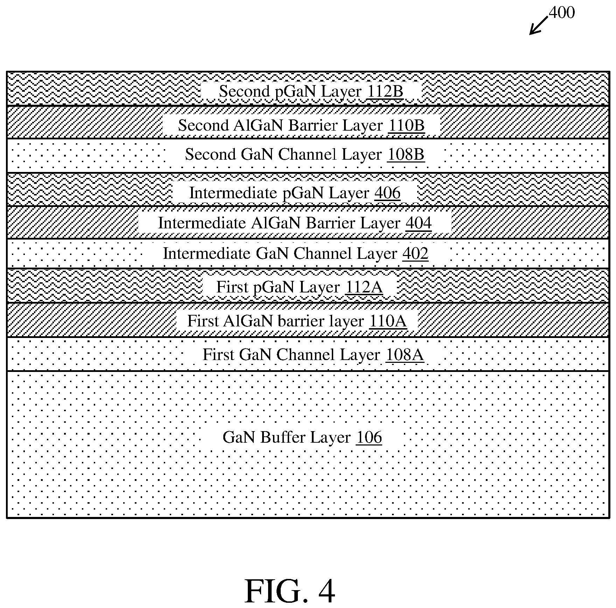

FIG. 4 is a schematic illustration of a member, in accordance with yet another embodiment of the present disclosure. FIG. 4 is described in conjunction with elements from the FIGs. 1A, 1B, 2A to 2G, and 3. With reference to FIG. 4, there is shown a schematic illustration of a member **400** that includes at least one intermediate gallium nitride (GaN) channel layer **402,** at least one intermediate aluminium gallium nitride (AlGaN) barrier layer **404,** and at least one intermediate p-doped gallium nitride (pGaN) layer **406.** The member **400** further includes the gallium nitride buffer layer **106,** the first gallium nitride channel layer **108A,** and the second gallium nitride channel layer **108B.** The member **300** further includes the first aluminium gallium nitride barrier layer **110A,** the second aluminium gallium nitride barrier layer **110B,** the first p-doped gallium nitride layer **112A,** and the second p-doped gallium nitride layer **112B.**

In accordance with an embodiment, the member **400** further comprises at least one intermediate gallium nitride (GaN) channel layer **402.** The member **400** further comprises at least one intermediate aluminium gallium nitride (AlGaN) barrier layer **404** arranged over the at least one intermediate gallium nitride (GaN) channel layer **402** and at least one intermediate p-doped gallium nitride (pGaN) layer **406** arranged over the at least one intermediate aluminium gallium nitride (AlGaN) barrier layer **404** respectively. The at least one intermediate gallium nitride (GaN) channel layer **402,** the at least one intermediate aluminium gallium nitride (AlGaN) barrier layer **404** and the at least one intermediate p-doped gallium nitride (pGaN) layer **406** are arranged between the first gallium nitride (GaN) channel layer **108A,** the first aluminium gallium nitride (AlGaN) barrier layer **110A,** the first p-doped gallium nitride (pGaN) layer **112A** and the second gallium nitride (GaN) channel layer **108B,** the second aluminium gallium nitride (AlGaN) barrier layer **110B,** the second p-doped gallium nitride (pGaN) layer **112B.** In other words, the member **400** further includes at least one intermediate epitaxial stack layer, which further includes a batch of three layers, such as the at least one intermediate gallium nitride channel layer **402,** the at least one intermediate aluminium gallium nitride barrier layer **404,** and the at least one intermediate p-doped gallium nitride layer **406.** The at least one intermediate gallium nitride channel layer **402** of the member **400** is arranged over the first p-doped gallium nitride layer **112A,** and the at least one intermediate aluminium gallium nitride barrier layer **404** is arranged over the at least one intermediate gallium nitride channel layer **402.** In addition, the at least one intermediate p-doped gallium nitride layer **406** is arranged over the at least one intermediate aluminium gallium nitride barrier layer **404.** Therefore, the member **400** includes the at least one intermediate epitaxial stack layer that is arranged over the first epitaxial stack layer. In an example, doping degree, as well as dimensions of each layer of the at least one intermediate epitaxial stack layer, are beneficial to achieve the desired performance as well as the desired reliability.

The member **400** further includes the second epitaxial stack layer, which is arranged over the at least one intermediate epitaxial stack layer. For example, the second gallium nitride channel layer **108B** of the second epitaxial stack layer is arranged over the at least one intermediate p-doped gallium nitride layer **406** of the at least one intermediate epitaxial stack layer. Thereafter, the second aluminium gallium nitride barrier layer **110B** is arranged over the second gallium nitride channel layer **108B,** and the second p-doped gallium nitride layer **112B** is arranged over the second aluminium gallium nitride barrier layer **110B.** By virtue of using the at least one intermediate gallium nitride channel layer **402,** the at least one intermediate aluminium gallium nitride barrier layer **404,** and the at least one intermediate p-doped gallium nitride layer **406,** the member **400** achieves an improved reliability.

In an implementation, the member **400** includes a contemporary use of the two-dimensional electron gas **302** (of FIG. 3) that is formed at an interface between the at least one intermediate aluminium gallium nitride barrier layer **404,** and the at least one intermediate gallium nitride channel layer **402.** By virtue of using the two-dimensional electron gas **302,** the member **400** is less prone to dynamic effects due to surface defects, and also to thickness variation caused by process variations.

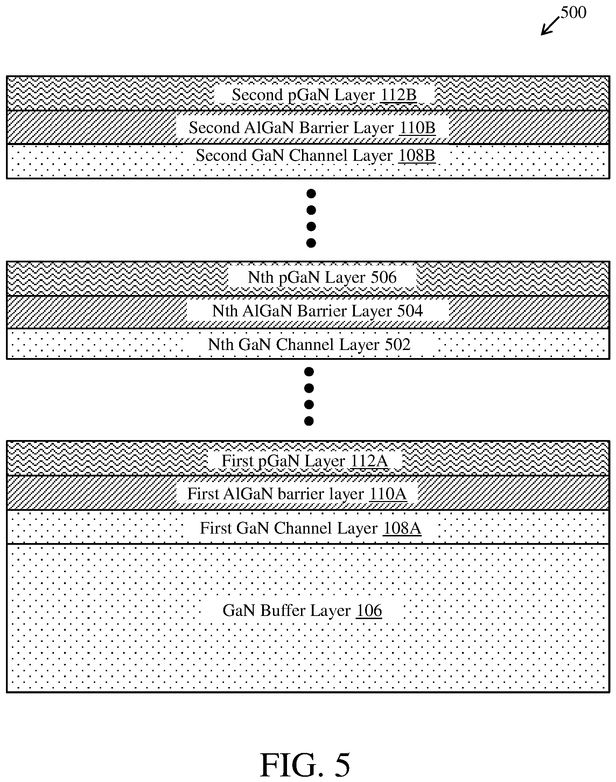

FIG. 5 is a schematic illustration of a member, in accordance with another embodiment of the present disclosure. FIG. 5 is described in conjunction with elements from the FIGs. 1A, 1B, 2A to 2G, 3 and 4. With reference to FIG. 5, there is shown a schematic illustration of a member **500** that includes N^{th} gallium nitride (GaN) channel layer **502,** N^{th} aluminium gallium nitride (AlGaN) barrier layer **504,** and N^{th} p-doped gallium nitride (pGaN) layer **506.** The member **500** further includes the silicon base substrate layer **102** (not shown in FIG. 3), the transition layer **104** (not shown in FIG. 3), the gallium nitride buffer layer **106,** the first gallium nitride channel layer **108A,** and the second gallium nitride channel layer **108B.** The member **500** further includes the first aluminium gallium nitride barrier layer **110A,** the second aluminium gallium nitride barrier layer **110B,** the first p-doped gallium nitride layer **112A,** and the second p-doped gallium nitride layer **112B.**

In an implementation, the member **500** further includes N^{th} intermediate epitaxial stack layer, which further includes the N^{th} gallium nitride channel layer **502,** the N^{th} aluminium gallium nitride barrier layer **504,** and the N^{th} p-doped gallium nitride layer **506.** For example, the N^{th} intermediate epitaxial stack layer is arranged between the first epitaxial stack layer and the second epitaxial stack layer, as shown in FIG. 5. In an example, doping degree, as well as dimensions of each layer of the N^{th} intermediate epitaxial stack layer, are beneficial to achieve the desired performance as well as the desired reliability. By virtue of using the N^{th} gallium nitride channel layer **502,** the N^{th} aluminium gallium nitride barrier layer **504,** and the N^{th} p-doped gallium nitride layer **506,** the member **500** achieves an improved reliability. In an example, the member **500** includes a contemporary use of the two-dimensional electron gas **302** (of FIG. 3) that is formed at an interface between the N^{th} aluminium gallium nitride barrier layer **504,** and the N^{th} gallium nitride channel layer **502.** By virtue of using the two-dimensional electron gas **302,** the member **500** is less prone to dynamic effects due to surface defects, and also to thickness variation caused by process variations.

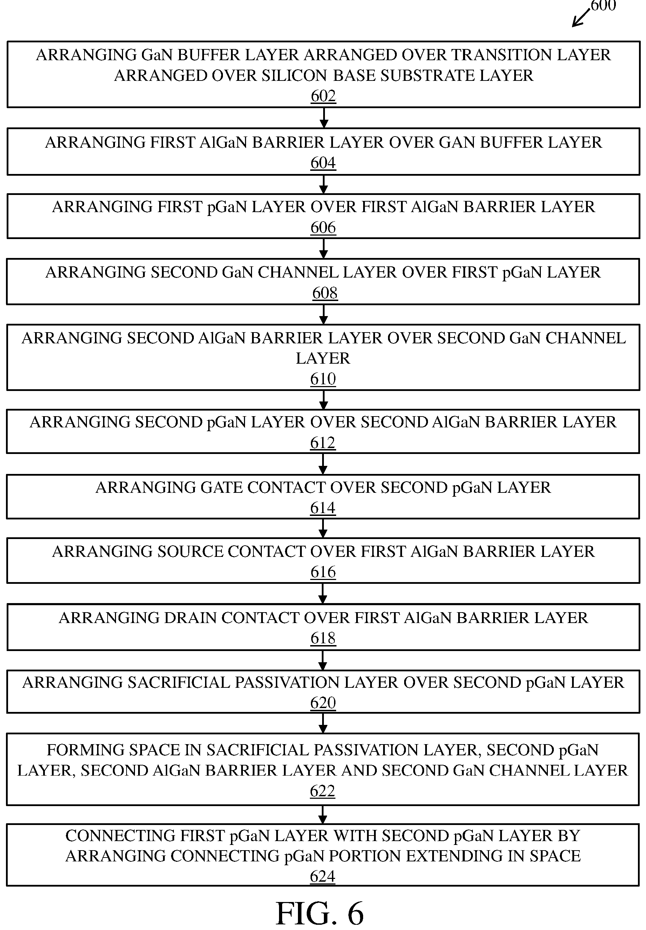

FIG. 6 is a flowchart of an exemplary method for an exemplary manufacturing a member, in accordance with an embodiment of the present disclosure, where the method is not part of the claimed invention. FIG. 6 is described in conjunction with elements from FIGs. 1A, 1B, 2A to 2G, 3, 4 and 5. With reference to FIG. 6, there is shown a method **600** that includes steps **602** and **624,** where the method is not part of the claimed invention.

In another aspect, the present disclosure provides a method **600** for manufacturing a member **100A.** The method **600** implies the use of at least two aluminium gallium nitride layers so as to increase the reliability of the member **100A.** The method **600** is applicable to all of the members **100A, 100B, 200A, 200B, 200C, 200D, 200E, 200F, 200G, 300,400** and **500.**

At step **602,** the method **600** comprises arranging a gallium nitride (GaN) buffer layer **106** arranged over a transition layer **104** arranged over a silicon base substrate layer **102.** In other words, the method **600** comprises arranging the silicon base substrate layer **102,** which is acting as a base of the member **100A.** Thereafter, the method **600** comprises, depositing the transition layer **104** on the silicon base substrate layer **102,** and then depositing the gallium nitride buffer layer **106** on the transition layer **104.** As a result, the member **100A** includes the silicon base substrate layer **102,** the transition layer **104,** and the gallium nitride buffer layer **106** (e.g., such as forming a GaN-On-Si substrate). Beneficially, the transition layer **104** provides sufficient strain relief and also limits (or prevents) the formation of cracks in the gallium nitride buffer layer **106.**

At step **604,** the method **600** comprises arranging a first aluminium gallium nitride (AlGaN) barrier layer **110A** over the gallium nitride (GaN) buffer layer **106.** As the first aluminium gallium nitride barrier layer **110A** is arranged over the gallium nitride buffer layer **106.** Thus, the member **100A** makes use of the properties of the gallium nitride buffer layer **106** to achieve higher electrical performance, for example, breakdown voltage (BV) for different semiconductor devices. In an implementation, the method **600** comprises, forming the first gallium nitride channel layer **108A** from a portion of the gallium nitride buffer layer **106,** where the first gallium nitride channel layer **108A** is in direct contact with the gallium nitride buffer layer **106.** In such implementation, the first aluminium gallium nitride barrier layer **110A** is arranged on the first gallium nitride channel layer **108A.**

At step **606,** the method **600** comprises arranging a first p-doped gallium nitride (pGaN) layer **112A** over the first aluminium gallium nitride (AlGaN) barrier layer **110A.** Therefore, method **600** provides a new device concept that makes use of a stacked layer approach in the member **100A,** and as well as the use of p-type doped gallium nitride, such as the first p-doped gallium nitride layer **112A.** As a result, the member **100A** includes a first epitaxial stack that includes a batch of three layers, such as the first gallium nitride channel layer **108A,** the first aluminium gallium nitride barrier layer **110A,** and the first p-doped gallium nitride layer **112A.**

At step **608,** the method 600 comprises arranging a second gallium nitride (GaN) channel layer **108B** over the first p-doped gallium nitride (pGaN) layer **112A.** Therefore, the method **600** is beneficial to co-integrate the first p-doped gallium nitride layer **112A** with the second gallium nitride (GaN) channel layer **108B.**

At step **610,** the method comprises arranging a second aluminium gallium nitride (AlGaN) barrier layer **110B** over the second gallium nitride (GaN) channel layer **108B.** By virtue of arranging the second aluminium gallium nitride barrier layer **110B** over the second gallium nitride channel layer **108B,** the method 600 achieves an electric field distribution along the second aluminium gallium nitride barrier layer **110B.** In an implementation, the method **600** comprises a contemporary use of the two-dimensional electron gas that forms at an interface between the second aluminium gallium nitride barrier layer **110B,** and the second gallium nitride channel layer **108B.** As a result, the member **100A** achieves enhanced high voltage operation capability.

At step **612,** the method comprises arranging a second p-doped gallium nitride (pGaN) layer **112B** over the second aluminium gallium nitride (AlGaN) barrier layer **110B.** Beneficially, the member **100A** makes use of the p-type doping capability of gallium nitride technology, such as by arranging the second p-doped gallium nitride (pGaN) layer **112B** over the second aluminium gallium nitride (AlGaN) barrier layer **110B.** In an example, the doping degree for the second p-doped gallium nitride layer **112B** has a p-type concentration between 1e¹⁷ cubic centimetres (cm⁻³) and 5e¹⁸ cubic cm⁻³. As a result, the member **100** includes a second epitaxial stack that includes a batch of three layers, such as the second gallium nitride channel layer **108B,** the second aluminium gallium nitride barrier layer **110B,** and the second p-doped gallium nitride layer **112B.** Moreover, the second epitaxial stack is arranged over the first epitaxial stack.

At step **614,** the method **600** comprises arranging a gate contact **114** over the second p-doped gallium nitride (pGaN) layer **112B.** The gate contact **114** arranged over second p-doped gallium nitride (pGaN) layer **112B** is beneficial for further connections (e.g., for electrical supply purposes). In an example, the gate contact is arranged over the connecting p-doped gallium nitride portion **120.** The connecting p-doped gallium nitride portion **120** is beneficial to deplete a two-dimensional electron gas below the gate contact **114** and also to allow a normally-off device operation of the member **100A.**

At step **616,** the method comprises arranging a source contact **116** over the first aluminium gallium nitride (AlGaN) barrier layer **110A.** The source contact **116** arranged over the first aluminium gallium nitride barrier layer **110A** is beneficial for further connections (e.g., for electrical supply purposes).

At step **618,** the method comprises arranging a drain contact **118** over the first aluminium gallium nitride (AlGaN) barrier layer **110A.** The drain contact **118** arranged over the first aluminium gallium nitride barrier layer **110A** is beneficial for further connections (e.g., for electrical supply purposes). The method **600** of the present disclosure allows a drastic reduction in an electric field peak at an edge of the gate contact **114** and the drain contact **118** (or at the gate-drain edge).

At step **620,** the method **600** comprises arranging a sacrificial passivation layer over the second p-doped gallium nitride (pGaN) layer **112B.** The sacrificial passivation layer (or the passivation layer **202** of FIG. 2A) is beneficial to prevent oxidation of the second p-doped gallium nitride layer **112B.**

At step **622,** the method **600** comprises forming a space **304** in the sacrificial passivation layer, the second p-doped gallium nitride (pGaN) layer **112B,** the second aluminium gallium nitride (AlGaN) barrier layer **110B** and the second gallium nitride (GaN) channel layer **108B.** In an implementation, the method **600** comprises, forming the space **304,** such as by removing the sacrificial passivation layer from one point along with the second p-doped gallium nitride layer **112B,** the second aluminium gallium nitride barrier layer **110B** and the second gallium nitride (GaN) channel layer **108B.** As a result, the first p-doped gallium nitride layer **112A** is exposed through the space **204.** The space **304** is beneficial for a selective arrangement of the connecting p-doped gallium nitride portion **120.**

At step **624,** the method **600** comprises connecting the first p-doped gallium nitride (pGaN) layer **112A** with the second p-doped gallium nitride (pGaN) layer **112B** by arranging a connecting p-doped gallium nitride (pGaN) portion **120** extending in the space **204.** In other words, the method **600** comprises, arranging the connecting p-doped gallium nitride portion **120** within the space **204,** and also over the first p-doped gallium nitride layer **112A.** Therefore, selective placement of the connecting p-doped gallium nitride portion **120** is performed on the first p-doped gallium nitride layer **112A.** Moreover, the connecting p-doped gallium nitride portion **120** is in direct contact with the first p-doped gallium nitride layer **112A,** and also with the second p-doped gallium nitride layer **112B.** In an example, the connecting p-doped gallium nitride portion **120** also has a doping degree that ranges between 1e¹⁸ cm⁻³ and 5e¹⁹ cm⁻³.

The method **600** of the present disclosure allows a drastic reduction in an electric field peak at an edge of the gate contact **114** and the drain contact **118** (or at gate-drain edge). Moreover, due to the use of the second aluminium gallium nitride barrier layer **110B,** there exists a flat electric field distribution along the first aluminium gallium nitride barrier layer **110A** (and the second aluminium gallium nitride barrier layer **110B).** In addition, the method **600** is beneficial for achieving an improved breakdown voltage (BV), which allows having a drastic reduction in a semiconductor device dimensions for the same target breakdown voltage. The method **600** is also beneficial for improving the reliability of the semiconductor device without sacrificing the overall performance of the semiconductor device.

In accordance with an embodiment, the method **600** further comprises arranging the source contact **116** and the drain contact **118** by arranging a recess in the second aluminium gallium nitride (AlGaN) barrier layer **110B,** the second p-doped gallium nitride (pGaN) layer **112B** the second gallium nitride (GaN) channel layer **108B,** and the first p-doped gallium nitride (pGaN) layer **112A.** In an implementation, the method **600** comprises, arranging the recess (e.g., via etching) at each end of the member **100A,** such as at a left end as well as at a right end of the member **100A.** In an example, arranging the recess corresponds to making an opening in the second aluminium gallium nitride barrier layer **110B,** the second p-doped gallium nitride layer **112B** the second gallium nitride channel layer **108B,** and the first p-doped gallium nitride layer **112A.** As a result, the first aluminium gallium nitride barrier layer **110A** is exposed from a top view of the member **100A** (e.g., exposed or visible at both ends of the member **100A).** Thereafter, the source contact **116** is arranged one end (e.g., left end) of the first aluminium gallium nitride barrier layer **110A,** and the drain contact **118** is arranged at another end (e.g., right end) of the first aluminium gallium nitride barrier layer **110A.** As a result, the first p-doped gallium nitride layer **112A** is arranged between the source contact **116** and the drain contact **118.**

In an implementation, the method **600** further comprises arranging the source contact **116** and the drain contact **118** by arranging a recess in the second aluminium gallium nitride (AlGaN) barrier layer **110B,** the second p-doped gallium nitride (pGaN) layer **112B** the second gallium nitride (GaN) channel layer **108B,** the first p-doped gallium nitride (pGaN) layer **112A,** the first aluminium gallium nitride (AlGaN) barrier layer **110A,** and the gallium nitride (GaN) channel layer **108A.** In this case, the source contact **116** and the drain contact **118** are in direct contact with the GaN buffer layer **106.**

In an implementation, the source contact **116,** and the drain contact **118** form an ohmic-like contact with a two-dimensional electron gas, which is positioned at an interface between the first aluminium gallium nitride barrier layer **110A,** and the first gallium nitride channel layer **108A.** In addition, the source contact **116,** and the drain contact **118** are also laterally in contact with another two-dimensional electron gas (which is positioned at an interface between the second aluminium gallium nitride barrier layer **110B,** and the second gallium nitride channel layer **108B),** and with the second p-doped gallium nitride layer **112B.**

In accordance with another embodiment, the method **600** further comprises manufacturing a member **100A.** By virtue of manufacturing the member **100A,** using the method **600,** there exists a flat electric field distribution along the first aluminium gallium nitride barrier layer **110A** (and the second aluminium gallium nitride barrier layer **110B)** of the member **100A.** The method **600** is beneficial for improving the reliability of a semiconductor device without sacrificing the overall performance of the semiconductor device.

The steps **602** to **624** are only illustrative, and other alternatives can also be provided where one or more steps are added, one or more steps are removed, or one or more steps are provided in a different sequence without departing from the scope of the claims herein. For example, in some implementations, the step **614** may be executed after the step **616** and **618.** Alternatively, the step **616** and **618** may be executed in parallel or the sequence of execution may change without limiting the scope of the disclosure.

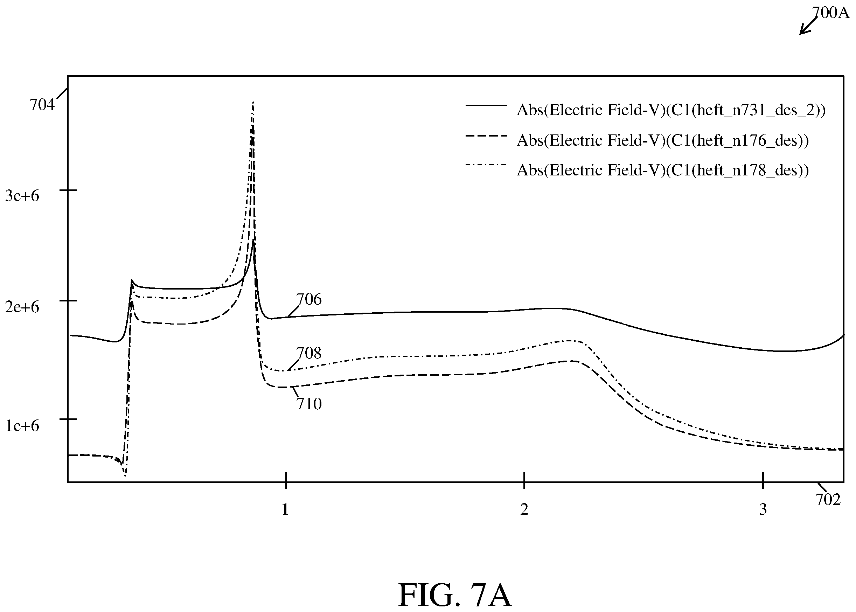

FIG. 7A is a graphical representation that illustrates an electric field cut along a direction of a gallium nitride channel layer within an aluminium gallium nitride barrier layer, during off-state conditions, in accordance with an embodiment of the present disclosure. FIG. 7A is described in conjunction with elements from FIGs. 1A, 1B, 2A to 2G, 3, 4 and 5. With reference to FIG. 7A, there is shown a graphical representation **700A** that illustrates an electric field cut along a direction of a gallium nitride channel layer within an aluminium gallium nitride barrier, during off-state conditions.

The graphical representation **700A** represents arbitrary units on the X-axis **702** and the electric field on the Y-axis **704.** In the graphical representation, the lines **708** and **710** illustrate electric field cut along direction of the gallium nitride channel layer within an aluminium gallium nitride barrier layer, during off-state conditions of a conventional approach. In particular, the line **706** illustrates the electric field cut along the direction of the gallium nitride channel layer within the aluminium gallium nitride barrier layer, during off-state conditions for the member **100A** of the present disclosure. For example, the electric field cut along the direction of the first gallium nitride channel layer **108A** within the first aluminium gallium nitride barrier layer **110A.** Similarly, the electric field cut along a direction of the second gallium nitride channel layer **108B** within the first aluminium gallium nitride barrier layer **110A,** during off-state conditions for the member **100A.** The line **706** illustrates that the member **100A** allows a massive reduction of the peak electric field in the second aluminium gallium nitride barrier layer **110B.** This, in turn, enables the member **100A** to significantly improve the overall device reliability of a semiconductor device.

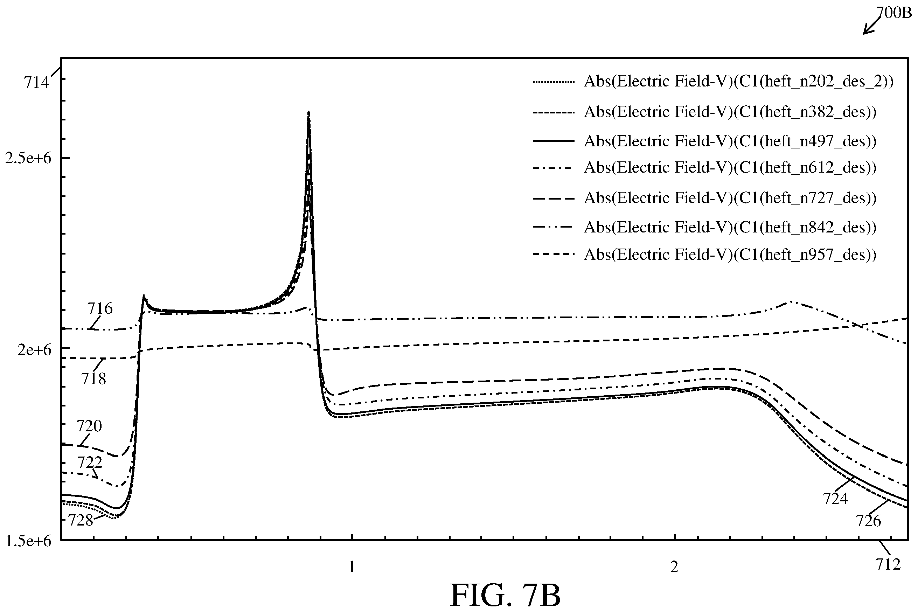

FIG. 7B is a graphical representation that illustrates an electric field cut along a direction of a gallium nitride channel layer within an aluminium gallium nitride barrier layer, during off-state conditions, for different p-type doping degrees in the p-doped gallium nitride layer, in accordance with an embodiment of the present disclosure. FIG. 7B is described in conjunction with elements from FIGs. 1A, 1B, 2A to 2G, 3, 4 and 5. With reference to FIG. 7B, there is shown a graphical representation **700B** that illustrates an electric field cut along a direction of a gallium nitride channel layer within an aluminium gallium nitride barrier layer, during off-state conditions, for different p-type doping degrees in a p-doped gallium nitride layer of the member **100A.**

The graphical representation **700B** represents arbitrary units on the X-axis **712** and the electric field on the Y-axis **714.** In particular, the lines **716, 718, 720, 722, 724, 726,** and **728** illustrates the electric field cut along direction of the gallium nitride channel layer within an aluminium gallium nitride barrier layer, during off-state conditions, for different p-type doping degree in the p-doped gallium nitride layer of the member **100A.** For example, the electric field cut along the direction of the first gallium nitride channel layer **108A** within the first aluminium gallium nitride barrier layer **110A,** during off-state conditions, and for different p-type doping in the first p-doped gallium nitride layer **112A** of the member **100A.** Similarly, the electric field cut along the direction of the second gallium nitride channel layer **108B** within the second aluminium gallium nitride barrier layer **110B,** during off-state conditions, for different p-type doping degrees in the second p-doped gallium nitride layer **112B** of the member **100A.**

The lines **716, 718, 720, 722, 724, 726,** and **728** illustrates a uniform doping concentration ranging from 1e¹⁶ cm⁻³ up to 5e¹⁸ cm⁻³. As visible from the lines **716, 718, 720, 722, 724, 726,** and **728,** when the p-type doping degree reaches a certain threshold, where compensation between the p-type and n-type carrier occurs. Then, a very flat electric field profile is obtained without any sharp peak at an interface of the aluminium gallium nitride barrier layer, and the gallium nitride channel layer. For example, at the interface of the first aluminium gallium nitride barrier layer **110A** and the first gallium nitride channel layer **108A,** and also at the interface of the second aluminium gallium nitride barrier layer **110B** and the second gallium nitride channel layer **108B.** As a result, different p-type doping degrees allows to greatly improve the overall reliability of the member **100A** and also boost the breakdown strength of the member **100A.**

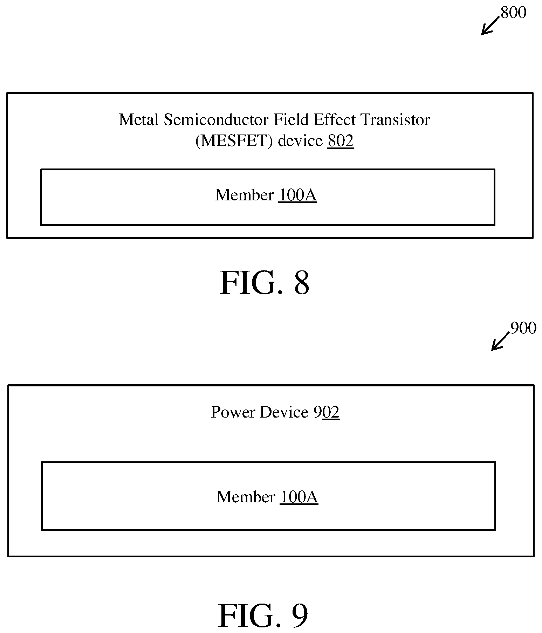

FIG. 8 is a block diagram of a metal-semiconductor field-effect transistor (MESFET) device, in accordance with an embodiment of the present disclosure. FIG. 8 is described in conjunction with elements from FIGs. 1A, 1B, 2A2A to 2G, 3, 4 and 5. With reference to FIG. 8, there is shown a block diagram **800** of a metal-semiconductor field-effect transistor (MESFET) device **802** that includes the member **100A.**

The MESFET device **802** is a semiconductor device, which is generally used to amplify or switch electronic signals. The MESFET device **802** is one of the basic building blocks of modern electronics. The MESFET device **802** is composed of semiconductor material.

In another aspect, the present disclosure provides a metal-semiconductor field-effect transistor (MESFET) device **802** comprising a member **100A.** By virtue of using the member **100A,** the MESFET device **802** achieves a very flat electric field profile, an improved reliability as well as improved breakdown strength.

FIG. 9 is a block diagram of a power device, in accordance with an embodiment of the present disclosure. FIG. 9 is described in conjunction with elements from FIGs. 1A, 1B, 2A to 2G, 3, 4 and 5. With reference to FIG. 9, there is shown a block diagram **900** of a power device **902** that includes the member **100A.**

The power device **902** is a semiconductor device that is used as a switch or rectifier in power electronics, such as in an integrated circuit or a power integrated circuit. Examples of the power device **902** include but are not limited to a power diode, a thyristor, an insulated-gate bipolar transistor (IGBT), and the like.

In yet another aspect, the present disclosure provides a power device **902** comprising the member **100A.** By virtue of using the member **100A,** the power device **902** achieves a very flat electric field profile, an improved reliability as well as an improved breakdown strength. The power device **902** (or gallium nitride power filed effect transistor) achieves an enhanced high voltage operation.

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural. The word "exemplary" is used herein to mean "serving as an example, instance or illustration". Any embodiment described as "exemplary" is not necessarily to be construed as preferred or advantageous over other embodiments or to exclude the incorporation of features from other embodiments. The word "optionally" is used herein to mean "is provided in some embodiments and not provided in other embodiments". It is appreciated that certain features of the present disclosure, which are, for clarity, described in the context of separate embodiments, may also be provided in combination in a single embodiment. Conversely, various features of the invention, which are, for brevity, described in the context of a single embodiment, may also be provided separately or in any suitable combination or as suitable in any other described embodiment of the disclosure.

## Claims

1. A member (100A, 100B, 200A, 200B, 200C, 200D, 200E, 200E, 200F, 200G, 300, 400, 500) comprising:
a silicon base substrate layer (102);
a transition layer (104) arranged over the silicon base substrate layer (102);
a gallium nitride (GaN) buffer layer (106) arranged over the transition layer (104),
a first aluminium gallium nitride (AlGaN) barrier layer (110A) arranged over the gallium nitride (GaN) buffer layer (106), and
a first p-doped gallium nitride (pGaN) layer (112A) arranged over the first aluminium gallium nitride (AlGaN barrier layer (110A), wherein a portion of the gallium nitride (GaN) buffer layer (106) forms a first gallium nitride (GaN) channel layer (108A), and wherein the first gallium nitride (GaN) channel layer (108A), the first aluminium gallium nitride (AlGaN) barrier layer (110A) and the first p-doped gallium nitride (pGaN) layer (112A) form a first epitaxial stack, wherein the member (100A, 100B, 200A, 200B, 200C, 200D, 200E, 200E, 200F, 200G, 300, 400, 500) further comprises:
a second gallium nitride (GaN) layer (108B) arranged over the first p-doped gallium nitride (pGaN) layer(112A);
a second aluminium gallium nitride (AlGaN) barrier layer (110B) arranged over the second gallium nitride (GaN) layer (108B), wherein the member is configured to form a two-dimensional electron gas at an interface between the second aluminium gallium nitride (AlGaN) barrier layer (110B) and the second gallium nitride (GaN) layer (108B):
a second p-doped gallium nitride (pGaN) layer (112B) arranged over the second aluminium gallium nitride (AlGaN) barrier layer (110B);
a source contact (116) arranged over the first aluminium gallium nitride (AlGaN) barrier layer (110A); and a drain contact (118) arranged over the first aluminium gallium nitride (AlGaN) barrier layer (110A), wherein the second p-doped gallium nitride (pGaN) layer (112B) is connected to the first p-doped gallium nitride (pGaN) layer (112A) by a connecting p-doped gallium nitride (pGaN) portion (120) extending through a space (204) in the second aluminium gallium nitride (AlGaN) barrier layer (110B) and the second gallium nitride (GaN) channel layer (108B), wherein the first p-doped gallium nitride (pGaN) layer (112A) is arranged between the source contact (116) and the drain contact (118), and wherein a gate contact (114) is arranged over the connecting p-doped gallium nitride (pGaN) portion (120).

2. The member (100A, 100B, 200A, 200B, 200C, 200D. 200E, 200E, 200F, 200G, 300, 400, 500) according to claim 1, wherein the connecting p-doped gallium nitride (pGaN) portion (120) connecting the first p-doped gallium nitride (pGaN) layer (112A) and the second p-doped gallium nitride (pGaN) layer (112B) is arranged to extend above an upper surface of the second p-doped gallium nitride (pGaN) layer (112B).

3. The member (100A, 100B, 200A, 200B, 200C, 200D, 200E, 200E, 200F, 200G, 300, 400, 500) according to any of claims 1 to 2, wherein
the first gallium nitride (GaN) channel layer (108A) has a first gallium nitride (GaN) channel layer thickness;
the first aluminium gallium nitride (AlGaN) barrier layer (110A) has a first aluminium gallium nitride (AlGaN) barrier layer thickness;
the first p-doped gallium nitride (pGaN) layer (112A) has a first p-doped gallium nitride (pGaN) layer thickness;
the second gallium nitride (GaN) layer (108B) has a second gallium nitride (GaN) layer thickness;
the second aluminium gallium nitride (AlGaN) barrier layer (110B) has a second aluminium gallium nitride (AlGaN) barrier layer thickness;
the second p-doped gallium nitride (pGaN) layer (112B) has a second p-doped gallium nitride (pGaN) layer thickness; and wherein
the second gallium nitride (GaN) layer thickness equals the first gallium nitride (GaN) channel layer thickness,
the second aluminium gallium nitride (AlGaN) barrier layer thickness equals the first aluminium gallium nitride (AlGaN) barrier layer thickness and/or
the second p-doped gallium nitride (pGaN) layer thickness equals the first p-doped gallium nitride (pGaN) layer thickness.

4. The member (100A, 100B, 200A, 200B, 200C, 200D, 200E, 200E, 200F, 200G, 300, 400, 500) according to any of claims 1 to 2, wherein
the first gallium nitride (GaN) channel layer (108A) has a first gallium nitride (GaN) channel layer thickness;
the first aluminium gallium nitride (AlGaN) barrier layer (110A) has a first aluminium gallium nitride (AlGaN) barrier layer thickness;
the first p-doped gallium nitride (pGaN) layer (112A) has a first p-doped gallium nitride (pGaN) layer thickness;
the second gallium nitride (GaN) layer (108B) has a second gallium nitride (GaN) layer thickness;
the second aluminium gallium nitride (AlGaN) barrier layer (110B) has a second aluminium gallium nitride (AlGaN) barrier layer thickness;
the second p-doped gallium nitride (pGaN) layer (112B) has a second p-doped gallium nitride (pGaN) layer thickness; and wherein
the second gallium nitride (GaN) layer thickness differs from the first gallium nitride (GaN) channel layer thickness;
the second aluminium gallium nitride (AlGaN) barrier layer thickness differs from the first aluminium gallium nitride (AlGaN) barrier layer thickness;
the second p-doped gallium nitride (pGaN) layer thickness differs from the first p-doped gallium nitride (pGaN) layer thickness.

5. The member (100A, 100B, 200A, 200B, 200C, 200D, 200E, 200E, 200F, 200G, 300, 400, 500) according to claim 3 or 4, wherein
the first gallium nitride (GaN) channel layer thickness ranges between 100 nanometre (nm) to 500 nm;
the first aluminium gallium nitride (AlGaN) barrier layer thickness ranges between 10 nm to 30 nm;
the first p-doped gallium nitride (pGaN) layer thickness ranges between 5 nm to 100 nm;
the second gallium nitride (GaN) layer thickness ranges between 10 nm to 200 nm;
the second aluminium gallium nitride (AlGaN) barrier layer thickness ranges between 10 nm to 30 nm; and/or
the second p-doped gallium nitride (pGaN) layer thickness ranges between 5 nm to 100 nm.

6. The member (100A, 100B, 200A, 200B, 200C, 200D, 200E, 200E, 200F, 200G, 300, 400, 500) according to any preceding claim, wherein
the first aluminium gallium nitride (AlGaN) barrier layer (110A) has a doping degree in the range of an aluminium content between 15% and 25%;
the first p-doped gallium nitride (pGaN) layer (112A) has a doping degree in the range of a p-type concentration between 1e¹⁷ cubic centimetres (cm⁻³) and 5e¹⁸ cm⁻³;
the second aluminium gallium nitride (AlGaN) barrier layer (110B) has a doping degree in the range of an aluminium content between 15% and 25%; and/or
the second p-doped gallium nitride (pGaN) layer (112B) has a doping degree in the range of a p-type concentration between 1e¹⁷ cubic centimetres (cm⁻³) and 5e¹⁸ cm⁻³.

7. The member (100A, 100B, 200A, 200B, 200C, 200D, 200E, 200E, 200F, 200G, 300, 400, 500) according to any preceding claim, wherein the member (100A, 100B, 200A, 200B, 200C, 200D, 200E, 200E, 200F, 200G, 300, 400, 500) further comprises a passivation layer (202) arranged over the second p-doped gallium nitride (pGaN ) layer (112B) and wherein the connecting p-doped gallium nitride (pGaN) portion (120) extends through the passivation layer (202).

8. The member (100A, 100B, 200A, 200B, 200C, 200D, 200E, 200E, 200F, 200G, 300, 400, 500) according to claim 7, wherein the passivation layer (202) extends between the source contact (116) and the first p-doped gallium nitride (pGaN) layer (112A) and between the drain contact (118) and the first p-doped gallium nitride (pGaN) layer (112A).

9. The member (100A, 100B, 200A, 200B, 200C, 200D, 200E, 200E, 200F, 200G, 300, 400, 500) according to claim 7 or 8, wherein the passivation layer (202) comprises aluminium oxide, aluminium nitride, silicon dioxide or silicon nitride.

10. The member (100A, 100B, 200A, 200B, 200C, 200D, 200E, 200E, 200F, 200G, 300, 400, 500) according to any preceding claim, wherein the member (100A, 100B, 200A, 200B, 200C, 200D, 200E, 200E, 200F, 200G, 300, 400, 500) further comprises at least one intermediate gallium nitride (GaN) channel layer (108C), at least one intermediate aluminium gallium nitride (AlGaN) barrier layer (110C) arranged over the at least one intermediate gallium nitride (GaN) channel layer (108C) and at least one intermediate p-doped gallium nitride (pGaN) layer (112C) arranged over the at least one intermediate aluminium gallium nitride (AlGaN) barrier layer (110C) respectively, wherein the at least one intermediate gallium nitride (GaN) channel layer (108C), the at least one intermediate aluminium gallium nitride (AlGaN) barrier layer (110C) and the at least one intermediate p-doped gallium nitride (pGaN) layer (112C) are arranged between
the first gallium nitride (GaN) channel layer (108A), the first aluminium gallium nitride (AlGaN) barrier layer (110A), the first p-doped gallium nitride (pGaN) layer (112A) on the one hand, and the second gallium nitride (GaN) layer (108B), the second aluminium gallium nitride (AlGaN) barrier layer (110B), the second p-doped gallium nitride (pGaN) layer (112B) on the other hand.

11. The member (100A, 100B, 200A, 200B, 200C, 200D, 200E, 200E, 200F, 200G, 300, 400, 500) according to any preceding claim, wherein the first gallium nitride (GaN) channel layer (108A) comprises an un-intentionally doped (UID) layer.

12. The member (100A, 100B, 200A, 200B, 200C, 200D, 200E, 200E, 200F, 200G, 300, 400, 500) according to any preceding claim, wherein at least one of the drain contact (118), the gate contact (114) and/or the source contact (116) is ohmic or Schottky.

13. A metal-semiconductor field-effect transistor (MESFET) device (802) comprising a member (100A,100B, 100C, 200, 300, 400, 500A, 500B, 500C, 500D) according to any of claims 1 to 12.

14. A power device (902) comprising the member (100A, 100B, 200A, 200B, 200C, 200D, 200E, 200E, 200F, 200G, 300, 400, 500) according to any of claims 1 to 12.

## Patentansprüche

1. Element (100A, 100B, 200A, 200B, 200C, 200D, 200E, 200E, 200F, 200G, 300, 400, 500), umfassend:
eine Siliciumbasis-Substratschicht (102);
eine Übergangsschicht (104), die über der Siliciumbasis-Substratschicht (102) angeordnet ist;
eine Galliumnitrid(GaN)-Pufferschicht (106), die über der Übergangsschicht (104) angeordnet ist,
eine erste Aluminiumgalliumnitrid(AlGaN)-Sperrschicht (110A), die über der Galliumnitrid(GaN)-Pufferschicht (106) angeordnet ist, und
eine erste p-dotierte Galliumnitrid(pGaN)-Schicht (112A), die über der ersten Aluminiumgalliumnitrid(AlGaN-Sperrschicht (110A) angeordnet ist, wobei ein Abschnitt der Galliumnitrid(GaN)-Pufferschicht (106) eine erste Galliumnitrid(GaN)-Kanalschicht (108A) ausbildet, und wobei die erste Galliumnitrid(GaN)-Kanalschicht (108A), die erste Aluminiumgalliumnitrid(AlGaN)-Sperrschicht (110A) und die erste p-dotierte Galliumnitrid(pGaN)-Schicht (112A) einen ersten Epitaxiestapel ausbilden, wobei das Element (100A, 100B, 200A, 200B, 200C, 200D, 200E, 200E, 200F, 200G, 300, 400, 500) ferner Folgendes umfasst:
eine zweite Galliumnitrid(GaN)-Schicht (108B), die über der ersten p-dotierten Galliumnitrid(pGaN)-Schicht (112A) angeordnet ist;
eine zweite Aluminiumgalliumnitrid(AlGaN)-Sperrschicht (110B), die über der zweiten Galliumnitrid(GaN)-Schicht (108B) angeordnet ist, wobei das Element dazu konfiguriert ist, ein zweidimensionales Elektronengas an einer Grenzfläche zwischen der zweiten Aluminiumgalliumnitrid(AlGaN)-Sperrschicht (110B) und der zweiten Galliumnitrid(GaN)-Schicht (108B) auszubilden;
eine zweite p-dotierte Galliumnitrid(pGaN)-Schicht (112B), die über der zweiten Aluminiumgalliumnitrid(AlGaN)-Sperrschicht (110B) angeordnet ist;
einen Source-Kontakt (116), der über der ersten Aluminiumgalliumnitrid(AlGaN)-Sperrschicht (110A) angeordnet ist;
und einen Drain-Kontakt (118), der über der ersten Aluminiumgalliumnitrid(AlGaN)-Sperrschicht (110A) angeordnet ist,
wobei die zweite p-dotierte Galliumnitrid(pGaN)-Schicht (112B) mit der ersten p-dotierten Galliumnitrid(pGaN)-Schicht (112A) durch einen verbindenden p-dotierten Galliumnitrid(pGaN)-Abschnitt (120) verbunden ist, der sich durch einen Raum (204) in der zweiten Aluminiumgalliumnitrid(AlGaN)-Sperrschicht (110B) und der zweiten Galliumnitrid(GaN)-Kanalschicht (108B) erstreckt, wobei die erste p-dotierte Galliumnitrid(pGaN)-Schicht (112A) zwischen dem Source-Kontakt (116) und dem Drain-Kontakt (118) angeordnet ist, und wobei ein Gate-Kontakt (114) über dem verbindenden p-dotierten Galliumnitrid(pGaN)-Abschnitt angeordnet ist (120).

2. Element (100A, 100B, 200A, 200B, 200C, 200D, 200E, 200E, 200F, 200G, 300, 400, 500) nach Anspruch 1, wobei der verbindende p-dotierte Galliumnitrid(pGaN)-Abschnitt (120), der die erste p-dotierte Galliumnitrid(pGaN)-Schicht (112A) und die zweite p-dotierte Galliumnitrid(pGaN)-Schicht (112B) verbindet, so angeordnet ist, dass er sich über eine obere Oberfläche der zweiten p-dotierten Galliumnitrid(pGaN)-Schicht (112B) erstreckt.

3. Element (100A, 100B, 200A, 200B, 200C, 200D, 200E, 200E, 200F, 200G, 300, 400, 500) nach einem der Ansprüche 1 bis 2, wobei die erste Galliumnitrid(GaN)-Kanalschicht (108A) eine erste Galliumnitrid(GaN)-Kanalschichtdicke aufweist;
die erste Aluminiumgalliumnitrid(AlGaN)-Sperrschicht (110A) eine erste Aluminiumgalliumnitrid(AlGaN)-Sperrschichtdicke aufweist;
die erste p-dotierte Galliumnitrid(pGaN)-Schicht (112A) eine erste p-dotierte Galliumnitrid(pGaN)-Schichtdicke aufweist;
die zweite Galliumnitrid(GaN)-Schicht (108B) eine zweite Galliumnitrid(GaN)-Schichtdicke aufweist;
die zweite Aluminiumgalliumnitrid(AlGaN)-Sperrschicht (110B) eine zweite Aluminiumgalliumnitrid(AlGaN)-Sperrschichtdicke aufweist;
die zweite p-dotierte Galliumnitrid(pGaN)-Schicht (112B) eine zweite p-dotierte Galliumnitrid(pGaN)-Schicht aufweist; und wobei die zweite Galliumnitrid(GaN)-Schichtdicke der ersten Galliumnitrid(GaN)-Kanalschichtdicke entspricht,
die zweite Aluminiumgalliumnitrid(AlGaN)-Sperrschichtdicke der ersten Aluminiumgalliumnitrid(AlGaN)-Sperrschichtdicke entspricht und/oder
die zweite p-dotierte Galliumnitrid(pGaN)-Schichtdicke der ersten p-dotierten Galliumnitrid(pGaN)-Schichtdicke entspricht.

4. Element (100A, 100B, 200A, 200B, 200C, 200D, 200E, 200E, 200F, 200G, 300, 400, 500) nach einem der Ansprüche 1 bis 2, wobei
die erste Galliumnitrid(GaN)-Kanalschicht (108A) eine erste Galliumnitrid(GaN)-Kanalschichtdicke aufweist;
die erste Aluminiumgalliumnitrid(AlGaN)-Sperrschicht (110A) eine erste Aluminiumgalliumnitrid(AlGaN)-Sperrschichtdicke aufweist; die erste p-dotierte Galliumnitrid(pGaN)-Schicht (112A) eine erste p-dotierte Galliumnitrid(pGaN)-Schichtdicke aufweist;
die zweite Galliumnitrid(GaN)-Schicht (108B) eine zweite Galliumnitrid(GaN)-Schichtdicke aufweist;
die zweite Aluminiumgalliumnitrid(AlGaN)-Sperrschicht (110B) eine zweite Aluminiumgalliumnitrid(AlGaN)-Sperrschichtdicke aufweist;
die zweite p-dotierte Galliumnitrid(pGaN)-Schicht (112B) eine zweite p-dotierte Galliumnitrid(pGaN)-Schicht aufweist; und wobei die zweite Galliumnitrid(GaN)-Schichtdicke sich von der ersten Galliumnitrid(GaN)-Kanalschichtdicke unterscheidet;
die zweite Aluminiumgalliumnitrid(AlGaN)-Sperrschichtdicke sich von der ersten Aluminiumgalliumnitrid(AlGaN)-Sperrschichtdicke unterscheidet;
die zweite p-dotierte Galliumnitrid(pGaN)-Schichtdicke sich von der ersten p-dotierten Galliumnitrid(pGaN)-Schichtdicke unterscheidet.

5. Element (100A, 100B, 200A, 200B, 200C, 200D, 200E, 200E, 200F, 200G, 300, 400, 500) nach einem der Ansprüche 3 oder 4, wobei
die erste Galliumnitrid(GaN)-Kanalschichtdicke zwischen 100 Nanometern (nm) und 500 nm liegt;
die erste Aluminiumgalliumnitrid(AlGaN)-Sperrschichtdicke zwischen 10 nm und 30 nm liegt;
die erste p-dotierte Galliumnitrid(pGaN)-Schichtdicke zwischen 5 nm und 100 nm liegt;
die zweite Galliumnitrid(GaN)-Schichtdicke zwischen 10 nm und 200 nm liegt;
die zweite Aluminiumgalliumnitrid(AlGaN)-Sperrschichtdicke zwischen 10 nm und 30 nm liegt; und/oder
die zweite p-dotierte Galliumnitrid(pGaN)-Schichtdicke zwischen 5 nm und 100 nm liegt.

6. Element (100A, 100B, 200A, 200B, 200C, 200D, 200E, 200E, 200F, 200G, 300, 400, 500) nach einem der vorhergehenden Ansprüche, wobei die erste Aluminiumgalliumnitrid(AlGaN)-Sperrschicht (110A) einen Dotierungsgrad im Bereich eines Aluminiumgehalts zwischen 15 % und 25 % aufweist;
die erste p-dotierte Galliumnitrid(pGaN)-Schicht (112A) einen Dotierungsgrad im Bereich einer p-Typ-Konzentration zwischen 1e¹⁷ Kubikzentimetern (cm⁻³) und 5e¹⁸ cm⁻³ aufweist;
die zweite Aluminiumgalliumnitrid(AlGaN)-Sperrschicht (110B) einen Dotierungsgrad im Bereich eines Aluminiumgehalts zwischen 15 % und 25 % aufweist; und/oder
die zweite p-dotierte Galliumnitrid(pGaN)-Schicht (112B) einen Dotierungsgrad im Bereich einer p-Typ-Konzentration zwischen 1e¹⁷ Kubikzentimetern (cm⁻³) und 5e¹⁸ cm⁻³ aufweist.

7. Element (100A, 100B, 200A, 200B, 200C, 200D, 200E, 200E, 200F, 200G, 300, 400, 500) nach einem der vorhergehenden Ansprüche, wobei das Element (100A, 100B, 200A, 200B, 200C, 200D, 200E, 200E, 200F, 200G, 300, 400, 500) ferner eine Passivierungsschicht (202) umfasst, die über der zweiten p-dotierten Galliumnitrid(pGaN)-Schicht (112B) angeordnet ist, und wobei sich der verbindende p-dotierte Galliumnitrid(pGaN)-Abschnitt (120) durch die Passivierungsschicht (202) erstreckt.

8. Element (100A, 100B, 200A, 200B, 200C, 200D, 200E, 200E, 200F, 200G, 300, 400, 500) nach Anspruch 7, wobei sich die Passivierungsschicht (202) zwischen dem Source-Kontakt (116) und der ersten p-dotierten Galliumnitrid(pGaN)-Schicht (112A) und zwischen dem Drain-Kontakt (118) und der ersten p-dotierten Galliumnitrid(pGaN)-Schicht (112A) erstreckt.

9. Element (100A, 100B, 200A, 200B, 200C, 200D, 200E, 200E, 200F, 200G, 300, 400, 500) nach Anspruch 7 oder 8, wobei die Passivierungsschicht (202) Aluminiumoxid, Aluminiumnitrid, Siliciumdioxid oder Siliciumnitrid umfasst.

10. Element (100A, 100B, 200A, 200B, 200C, 200D, 200E, 200E, 200F, 200G, 300, 400, 500) nach einem der vorhergehenden Ansprüche, wobei das Element (100A, 100B, 200A, 200B, 200C, 200D, 200E, 200E, 200F, 200G, 300, 400, 500) ferner jeweils mindestens eine Galliumnitrid(GaN)-Zwischenkanalschicht (108C), mindestens eine Aluminiumgalliumnitrid(AlGaN)-Zwischensperrschicht (110C), die über der mindestens einen Galliumnitrid(GaN)-Zwischenkanalschicht (108C) angeordnet ist, und mindestens eine p-dotierte Galliumnitrid(pGaN)-Zwischenschicht (112C), die über der mindestens einen Aluminiumgalliumnitrid(AlGaN)-Zwischensperrschicht (110C) angeordnet ist, umfasst, wobei die mindestens eine Galliumnitrid(GaN)-Zwischenkanalschicht (108C), die mindestens eine Aluminiumgalliumnitrid(AlGaN)-Zwischensperrschicht (110C) und die mindestens eine p-dotierte Galliumnitrid(pGaN)-Zwischenschicht (112C) angeordnet sind zwischen
der ersten Galliumnitrid(GaN)-Kanalschicht (108A), der ersten Aluminiumgalliumnitrid(AlGaN)-Sperrschicht (110A),
der ersten p-dotierten Galliumnitrid(pGaN)-Schicht (112A) einerseits und der zweiten Galliumnitrid(GaN)-Schicht (108B), der zweiten Aluminiumgalliumnitrid(AlGaN)-Sperrschicht (110B), der zweiten p-dotierten Galliumnitrid(pGaN)-Schicht (112B) andererseits.

11. Element (100A, 100B, 200A, 200B, 200C, 200D, 200E, 200E, 200F, 200G, 300, 400, 500) nach einem der vorhergehenden Ansprüche, wobei die erste Galliumnitrid(GaN)-Kanalschicht (108A) eine unbeabsichtigt dotierte (UID)-Schicht umfasst.

12. Element (100A, 100B, 200A, 200B, 200C, 200D, 200E, 200E, 200F, 200G, 300, 400, 500) nach einem der vorhergehenden Ansprüche, wobei mindestens einer von dem Drain-Kontakt (118), dem Gate-Kontakt (114) und/oder dem Source-Kontakt (116) ein Ohm'scher oder ein Schottky-Kontakt ist.

13. Metall-Halbleiter-Feldeffekttransistor(MESFET)-Vorrichtung (802), umfassend ein Element (100A, 100B, 100C, 200, 300, 400, 500A, 500B, 500C, 500D) nach einem der Ansprüche 1 bis 12.

14. Leistungsvorrichtung (902), umfassend das Element (100A, 100B, 200A, 200B, 200C, 200D, 200E, 200E, 200F, 200G, 300, 400, 500) nach einem der Ansprüche 1 bis 12.

## Revendications

1. Élément (100A, 100B, 200A, 200B, 200C, 200D, 200E, 200E, 200F, 200G, 300, 400, 500) comprenant :
une couche de substrat de base en silicium (102) ;
une couche de transition (104) disposée sur la couche de substrat de base en silicium (102) ;
une couche tampon en nitrure de gallium (GaN) (106) disposée sur la couche de transition (104),
une première couche barrière en nitrure d'aluminium-gallium (AlGaN) (110A) disposée sur la couche tampon en nitrure de gallium (GaN) (106), et
une première couche en nitrure de gallium dopé p (pGaN) (112A) disposée sur la première couche barrière en nitrure d'aluminium-gallium (AlGaN) (110A), dans lequel une partie de la couche tampon en nitrure de gallium (GaN) (106) forme une première couche de canal en nitrure de gallium (GaN) (108A), et dans lequel la première couche de canal en nitrure de gallium (GaN) (108A), la première couche barrière en nitrure d'aluminium-gallium (AlGaN) (110A) et la première couche en nitrure de gallium dopé p (pGaN) (112A) forment un premier empilement épitaxial, dans lequel l'élément (100A, 100B, 200A, 200B, 200C, 200D, 200E, 200E, 200F, 200G, 300, 400, 500) comprend également :
une seconde couche en nitrure de gallium (GaN) (108B) disposée sur la première couche en nitrure de gallium dopé p (pGaN) (112A) ;
une seconde couche barrière en nitrure d'aluminium-gallium (AlGaN) (110B) disposée sur la seconde couche en nitrure de gallium (GaN) (108B), dans lequel l'élément est configuré pour former un gaz d'électrons bidimensionnel à une interface entre la seconde couche barrière en nitrure d'aluminium-gallium (AlGaN) (110B) et la seconde couche en nitrure de gallium (GaN) (108B) ;
une seconde couche en nitrure de gallium dopé p (pGaN) (112B) disposée sur la seconde couche barrière en nitrure d'aluminium-gallium (AlGaN) (110B) ;
un contact de source (116) disposé sur la première couche barrière en nitrure d'aluminium-gallium (AlGaN) (110A) ; et un contact de drain (118) disposé sur la première couche barrière en nitrure d'aluminium-gallium (AlGaN) (110A), dans lequel la seconde couche en nitrure de gallium dopé p (pGaN) (112B) est reliée à la première couche en nitrure de gallium dopé p (pGaN) (112A) par une partie de liaison en nitrure de gallium dopé p (pGaN) (120) se prolongeant à travers un espace (204) dans la seconde couche barrière en nitrure d'aluminium-gallium (AlGaN) (110B) et la seconde couche de canal en nitrure de gallium (GaN) (108B), dans lequel la première couche en nitrure de gallium dopé p (pGaN) (112A) est disposée entre le contact de source (116) et le contact de drain (118), et
dans lequel un contact de grille (114) est disposé sur la partie de liaison en nitrure de gallium dopé p (pGaN) (120).

2. Élément (100A, 100B, 200A, 200B, 200C, 200D, 200E, 200E, 200F, 200G, 300, 400, 500) selon la revendication 1, dans lequel la partie de liaison en nitrure de gallium dopé p (pGaN) (120) reliant la première couche en nitrure de gallium dopé p (pGaN) (112A) et la seconde couche en nitrure de gallium dopé p (pGaN) (112B) est disposée pour se prolonger au-dessus d'une surface supérieure de la seconde couche en nitrure de gallium dopé p (pGaN) (112B).

3. Élément (100A, 100B, 200A, 200B, 200C, 200D, 200E, 200E, 200F, 200G, 300, 400, 500) selon l'une quelconque des revendications 1 et 2, dans lequel
la première couche de canal en nitrure de gallium (GaN) (108A) a une première épaisseur de couche de canal en nitrure de gallium (GaN) ;
la première couche barrière en nitrure d'aluminium-gallium (AlGaN) (110A) a une première épaisseur de couche barrière en nitrure d'aluminium-gallium (AlGaN) ;
la première couche en nitrure de gallium dopé p (pGaN) (112A) a une première épaisseur de couche en nitrure de gallium dopé p (pGaN) ;
la seconde couche en nitrure de gallium (GaN) (108B) a une seconde épaisseur de couche en nitrure de gallium (GaN) ;
la seconde couche barrière en nitrure d'aluminium-gallium (AlGaN) (110B) a une seconde épaisseur de couche barrière en nitrure d'aluminium-gallium (AlGaN) ;
la seconde couche en nitrure de gallium dopé p (pGaN) (112B) a une seconde épaisseur de couche en nitrure de gallium dopé p (pGaN) ; et dans lequel
l'épaisseur de la seconde couche en nitrure de gallium (GaN) est égale à l'épaisseur de la première couche de canal en nitrure de gallium (GaN),
l'épaisseur de la seconde couche barrière en nitrure d'aluminium-gallium (AlGaN) est égale à l'épaisseur de la première couche barrière en nitrure d'aluminium-gallium (AlGaN) et/ou
l'épaisseur de la seconde couche en nitrure de gallium dopé p (pGaN) est égale à l'épaisseur de la première couche en nitrure de gallium dopé p (pGaN).

4. Élément (100A, 100B, 200A, 200B, 200C, 200D, 200E, 200E, 200F, 200G, 300, 400, 500) selon l'une quelconque des revendications 1 et 2, dans lequel
la première couche de canal en nitrure de gallium (GaN) (108A) a une première épaisseur de couche de canal en nitrure de gallium (GaN) ;
la première couche barrière en nitrure d'aluminium-gallium (AlGaN) (110A) a une première épaisseur de couche barrière en nitrure d'aluminium-gallium (AlGaN) ;
la première couche en nitrure de gallium dopé p (pGaN) (112A) a une première épaisseur de couche en nitrure de gallium dopé p (pGaN) ;
la seconde couche en nitrure de gallium (GaN) (108B) a une seconde épaisseur de couche en nitrure de gallium (GaN) ;
la seconde couche barrière en nitrure d'aluminium-gallium (AlGaN) (110B) a une seconde épaisseur de couche barrière en nitrure d'aluminium-gallium (AlGaN) ;
la seconde couche en nitrure de gallium dopé p (pGaN) (112B) a une seconde épaisseur de couche en nitrure de gallium dopé p (pGaN) ; et dans lequel
l'épaisseur de la seconde couche en nitrure de gallium (GaN) diffère de l'épaisseur de la première couche de canal en nitrure de gallium (GaN) ;
l'épaisseur de la seconde couche barrière en nitrure d'aluminium-gallium (AlGaN) diffère de l'épaisseur de la première couche barrière en nitrure d'aluminium-gallium (AlGaN) ;
l'épaisseur de la seconde couche en nitrure de gallium dopé p (pGaN) diffère de l'épaisseur de la première couche en nitrure de gallium dopé p (pGaN).

5. Élément (100A, 100B, 200A, 200B, 200C, 200D, 200E, 200E, 200F, 200G, 300, 400, 500) selon la revendication 3 ou 4, dans lequel l'épaisseur de la première couche de canal en nitrure de gallium (GaN) varie entre 100 nanomètres (nm) et 500 nm ;
l'épaisseur de la première couche barrière en nitrure d'aluminium-gallium (AlGaN) varie entre 10 nm et 30 nm ;
l'épaisseur de la première couche en nitrure de gallium dopé p (pGaN) varie entre 5 nm et 100 nm ;
l'épaisseur de la seconde couche en nitrure de gallium (GaN) varie entre 10 nm et 200 nm ;
l'épaisseur de la seconde couche barrière en nitrure d'aluminium-gallium (AlGaN) varie entre 10 nm et 30 nm ; et/ou
l'épaisseur de la seconde couche en nitrure de gallium dopé p (pGaN) varie entre 5 nm et 100 nm.

6. Élément (100A, 100B, 200A, 200B, 200C, 200D, 200E, 200E, 200F, 200G, 300, 400, 500) selon une quelconque revendication précédente, dans lequel
la première couche barrière en nitrure d'aluminium-gallium (AlGaN) (110A) a un degré de dopage compris entre 15 % et 25 % de teneur en aluminium ;
la première couche en nitrure de gallium dopé p (pGaN) (112A) a un degré de dopage compris dans la plage d'une concentration de type p comprise entre 1e¹⁷ centimètres cubes (cm⁻³) et 5e¹⁸ cm⁻³ ;
la seconde couche barrière en nitrure d'aluminium-gallium (AlGaN) (110B) a un degré de dopage compris entre 15 % et 25 % de teneur en aluminium ; et/ou
la seconde couche en nitrure de gallium dopé p (pGaN) (112B) a un degré de dopage compris dans la plage d'une concentration de type p comprise entre 1e¹⁷ centimètres cubes (cm⁻³) et 5e¹⁸ cm⁻³.

7. Élément (100A, 100B, 200A, 200B, 200C, 200D, 200E, 200E, 200F, 200G, 300, 400, 500) selon une quelconque revendication précédente, dans lequel l'élément (100A, 100B, 200A, 200B, 200C, 200D, 200E, 200E, 200F, 200G, 300, 400, 500), comprend également une couche de passivation (202) disposée sur la seconde couche en nitrure de gallium dopé p (pGaN) (112B) et dans lequel la partie de liaison (120) en nitrure de gallium dopé p (pGaN) se prolonge à travers la couche de passivation (202).

8. Élément (100A, 100B, 200A, 200B, 200C, 200D, 200E, 200E, 200F, 200G, 300, 400, 500) selon la revendication 7, dans lequel la couche de passivation (202) se prolonge entre le contact de source (116) et la première couche en nitrure de gallium dopé p (pGaN) (112A) et entre le contact de drain (118) et la première couche en nitrure de gallium dopé p (pGaN) (112A).

9. Élément (100A, 100B, 200A, 200B, 200C, 200D, 200E, 200E, 200F, 200G, 300, 400, 500) selon la revendication 7 ou 8, dans lequel la couche de passivation (202) comprend de l'oxyde d'aluminium, du nitrure d'aluminium, du dioxyde de silicium ou du nitrure de silicium.

10. Élément (100A, 100B, 200A, 200B, 200C, 200D, 200E, 200E, 200F, 200G, 300, 400, 500) selon une quelconque revendication précédente, dans lequel l'élément (100A, 100B, 200A, 200B, 200C, 200D, 200E, 200E, 200F, 200G, 300, 400, 500) comprend également au moins une couche intermédiaire de canal en nitrure de gallium (GaN) (108C), au moins une couche barrière intermédiaire en nitrure d'aluminium-gallium (AlGaN) (110C) disposée sur l'au moins une couche intermédiaire de canal en nitrure de gallium (GaN) (108C) et au moins une couche intermédiaire en nitrure de gallium dopé p (pGaN) (112C) disposée sur l'au moins une couche barrière intermédiaire en nitrure d'aluminium-gallium (AlGaN) (110C) respectivement, dans lequel l'au moins une couche intermédiaire de canal en nitrure de gallium (GaN) (108C), l'au moins une couche barrière intermédiaire en nitrure d'aluminium-gallium (AlGaN) (110C) et l'au moins une couche intermédiaire en nitrure de gallium dopé p (pGaN) (112C) sont disposées entre
la première couche de canal en nitrure de gallium (GaN) (108A), la première couche barrière en nitrure d'aluminium-gallium (AlGaN) (110A),
la première couche en nitrure de gallium dopé p (pGaN) (112A) d'une part, et la seconde couche en nitrure de gallium (GaN) (108B), la seconde couche barrière en nitrure d'aluminium-gallium (AlGaN) (110B), la seconde couche en nitrure de gallium dopé p (pGaN) (112B) d'autre part.

11. Élément (100A, 100B, 200A, 200B, 200C, 200D, 200E, 200E, 200F, 200G, 300, 400, 500) selon une quelconque revendication précédente, dans lequel la première couche de canal en nitrure de gallium (GaN) (108A) comprend une couche dopée non intentionnellement (UID).

12. Élément (100A, 100B, 200A, 200B, 200C, 200D, 200E, 200E, 200F, 200G, 300, 400, 500) selon une quelconque revendication précédente, dans lequel au moins l'un du contact de drain (118), du contact de grille (114) et/ou du contact de source (116) est ohmique ou Schottky.

13. Dispositif à transistors à effet de champ métal-semiconducteur (MESFET) (802) comprenant un élément (100A, 100B, 100C, 200, 300, 400, 500A, 500B, 500C, 500D) selon l'une quelconque des revendications 1 à 12.

14. Dispositif d'alimentation (902) comprenant l'élément (100A, 100B, 200A, 200B, 200C, 200D, 200E, 200E, 200F, 200G, 300, 400, 500) selon l'une quelconque des revendications 1 à 12.
